# EUROPEAN PATENT APPLICATION

(11) **EP 2 187 311 A1**
(43) Date of publication of application: **19.05.2010**
(21) Application number: 08764064.5
(22) Date of filing: 09.06.2008
(51) Int. Cl.: G06F 11/28

(54) **SEMICONDUCTOR DEVICE, AND DEVELOPMENT SUPPORTING DEVICE**

(30) Priority: 03.09.2007 JP 2007227594
(71) Applicant: Panasonic Corporation, Kadoma-shi Osaka 571-8501 (JP)
(72) Inventor: UBUKATA, Atsushi, Osaka 540-6207 (JP); TSUTSUI, Ryuta, Osaka 540-6207 (JP); OSAKA, Masataka, Osaka 540-6207 (JP); MINO, Yoshiteru, Osaka 540-6207 (JP); SEZAKI, Tomohisa, Osaka 540-6207 (JP); DOI, Hirotaka, Osaka 540-6207 (JP)
(74) Representative: Grünecker, Kinkeldey, Stockmair & Schwanhäusser Anwaltssozietät
(86) International application number: PCT/JP2008/001467
(87) International publication number: WO 2009/031254

(57) **Abstract**

States of LSI internal signals (100 to 107) are monitored. Signal name information (31), signal state information (32), and information (33) about time in an LSI when a signal undergoes a state transition, are packetized and output as trace information (10) to the outside. In a development supporting device, the trace information (10) is decoded, the time information of the LSI is converted into real-time information, and based on the resultant information, a waveform of an LSI internal signal is reproduced. A plurality of LSI internal signals can be traced using terminals (16) the number of which is smaller than the number of the signals to be traced.

## Description

### TECHNICAL FIELD

The present invention relates to a semiconductor device in which a state of an LSI internal signal can be externally traced, and a development supporting device employing the semiconductor device.

### BACKGROUND ART

In order to analyze the internal behavior of an LSI in real time, a signal inside the LSI needs to be traced outside the LSI. Therefore, conventionally, the signal to be traced is output to the outside of the LSI and is analyzed outside the LSI using a logic analyzer or the like.

However, as the number of LSI internal signals to be traced increases, the number of external terminals required for tracing increases in proportion to the number of the signals, leading to an increase in cost.

To avoid this, it may be contemplated that an external terminal having a normal function is also used as an external terminal for tracing. In this case, however, the normal function cannot be used during evaluation, which makes it difficult to evaluate all functions.

On the other hand, there is a known technique of controlling an internal selection circuit to select one from a plurality of LSI internal signals to be traced and output the selected signal to the outside of an LSI (see Patent Document 1).
Patent Document 1: Japanese Unexamined Patent Application Publication No. 2002-24201

### DISCLOSURE OF THE INVENTION

### PROBLEMS TO BE SOLVED BY THE INVENTION

However, conventionally, it is not possible to simultaneously trace LSI internal signals the number of which is larger than the number of external terminals for tracing. In other words, it is not assumed in conventional tracing techniques that the number of LSI internal signals to be simultaneously traced is increased. Therefore, when a plurality of LSI internal signals are traced in parallel, then if the number of the signals is increased, tracing is expected not to work.

In view of such a problem, an object of the present invention is to provide means for enabling simultaneous tracing of a plurality of LSI internal signals using a single external terminal.

### SOLUTION TO THE PROBLEMS

The aforementioned problem is solved by the present invention in which, instead of outputting an LSI internal signal directly to the outside of an LSI, a signal name and a signal state are acquired from information about a change in the state of an LSI internal signal to be traced, and are encoded together with information about time when the signal state is changed, and the encoded information is output to the outside of the LSI, and the encoded information is decoded outside the LSI to reproduce the LSI internal information.

### EFFECT OF THE INVENTION

According to the present invention, the presence or absence of operation of a plurality of LSI internal signals can be found based on information output through a single external terminal. Therefore, even when the number of LSI internal signals to be traced is larger than the number of external terminals for tracing, the LSI internal signals can be traced in parallel.

Also, by utilizing synchronization, a data amount of information for externally tracing an LSI internal signal can be reduced while keeping the content of the information. Moreover, by taking measures to avoid a loss of information that is likely to occur when LSI internal information is acquired, it is possible to reliably acquire necessary information.

### BRIEF DESCRIPTION OF THE DRAWINGS

FIG. 1 is a diagram schematically showing a configuration of a semiconductor device and a development supporting device according to the present invention.
FIG. 2 is a diagram showing a configuration of a semiconductor device according to a first embodiment of the present invention.
FIG. 3 is a diagram showing a configuration of a development supporting device according to the first embodiment of the present invention.
FIG. 4 is a diagram showing an algorithm for acquiring LSI internal information according to the first embodiment of the present invention.
FIG. 5 is a diagram showing a process of acquiring LSI internal information according to the first embodiment of the present invention.
FIG. 6 is a diagram showing an algorithm for decoding trace information by a debugger according to the first embodiment of the present invention.
FIG. 7 is a diagram showing a process of decoding trace information according to the first embodiment of the present invention.
FIG. 8 is a diagram showing an algorithm for reproducing LSI internal information by the debugger according to the first embodiment of the present invention.
FIG. 9 is a diagram showing a process of reproducing LSI internal information according to the first embodiment of the present invention.
FIG. 10 is a diagram showing a configuration of a semiconductor device according to a second embodiment of the present invention.
FIG. 11 is a diagram showing an algorithm for acquiring LSI internal information according to the second embodiment of the present invention.
FIG. 12 is a diagram showing a process of acquiring LSI internal information according to the second embodiment of the present invention.
FIGS. 13(a) to 13(d) are diagrams showing a loss of trace information and means for avoiding this.
FIG. 14 is a diagram showing a configuration of a semiconductor device according to a third embodiment of the present invention.
FIG. 15 is a diagram showing an algorithm for acquiring LSI internal information according to the third embodiment of the present invention.
FIG. 16 is a diagram showing a process of acquiring LSI internal information according to the third embodiment of the present invention.
FIG. 17 is a diagram showing a configuration of a semiconductor device according to a fourth embodiment of the present invention.
FIG. 18 is a diagram showing an algorithm for acquiring LSI internal information according to the fourth embodiment of the present invention.
FIG. 19 is a diagram showing a process of acquiring LSI internal information according to the fourth embodiment of the present invention.
FIG. 20 is a diagram showing a configuration of a semiconductor device according to a fifth embodiment of the present invention.
FIG. 21 is a diagram showing an algorithm for acquiring LSI internal information according to the fifth embodiment of the present invention.
FIG. 22 is a diagram showing a process of acquiring LSI internal information according to the fifth embodiment of the present invention.
FIG. 23 is a diagram showing a configuration of a semiconductor device according to a sixth embodiment of the present invention.
FIG. 24 is a diagram showing an algorithm for acquiring LSI internal information according to the sixth embodiment of the present invention.

### DESCRIPTION OF THE REFERENCE CHARACTERS

1 LSI (semiconductor device)
2 debugger (development supporting device)
10 trace information
11 to 15 functional block
16 trace information output terminal
17 LSI internal information acquiring unit
21 trace information decoding unit
22 LSI internal information reproducing unit
23 LSI internal information buffer
24 time information decoding unit
25 real-time conversion unit
26 waveform reproducing unit
31 signal name information (in LSI)
32 signal state information (in LSI)
33 time information (in LSI)
41 signal name information (in debugger)
42 signal state information (in debugger)
43 time information (in debugger)
44 synchronization information
45 LSI internal time information
46 real-time information
51 synchronization signal
52 data amount of trace information
53 synchronization cycle change information
54 synchronization occurrence cycle setting unit ON/OFF switching signal
55 event selection control unit ON/OFF switching signal
56 time information acquisition event selection control unit ON/OFF switching signal
100 to 107 LSI internal signal
200 trace information generating unit
201 time information acquisition event selection control unit
202 event-to-be-limited setting unit
203 hold buffer
204 output buffer
210 time information generating unit
211 synchronization signal generating unit
212 internal counter
213 synchronization occurrence cycle setting unit
220 signal identifying information generating unit
221 signal name information generating unit
222 signal state information generating unit
223 event selection control unit
224 event-to-be-limited setting unit
230 trace information loss avoiding means selection unit
240 trace information output unit

### BEST MODE FOR CARRYING OUT THE INVENTION

Hereinafter, embodiments of the present invention will be described in detail with reference to the accompanying drawings.

### «First Embodiment»

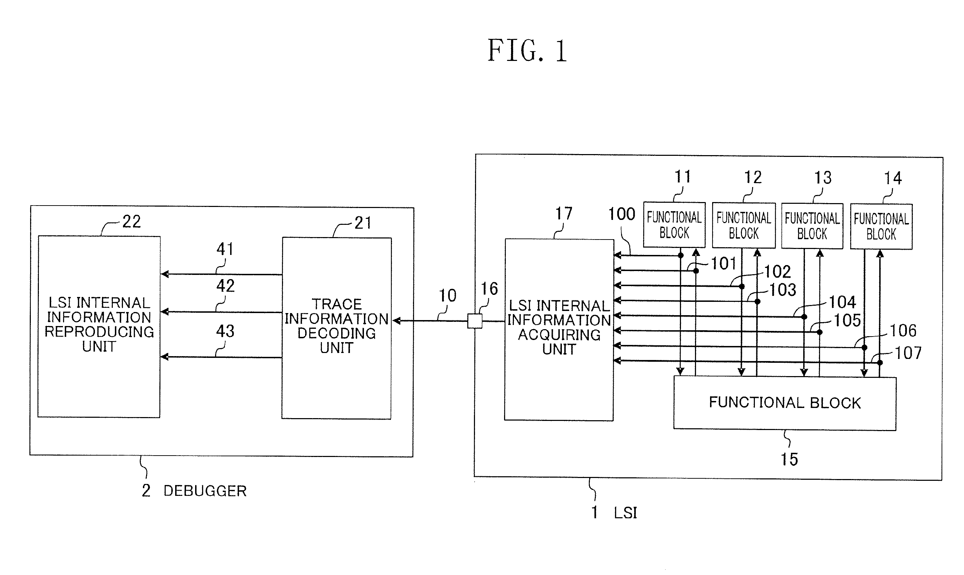

FIG. 1 schematically shows a whole configuration of a semiconductor device and a development supporting device according to the present invention. It is here assumed that internal signals 100 to 107 between functional blocks 11 to 14 and a functional block 15 in the semiconductor device (LSI) 1 are traced using the development supporting device (debugger) 2. An LSI internal information acquiring unit 17 supplies information indicating that a signal to be traced has undergone a state transition, as trace information 10, via a single output terminal 16 to the debugger 2. The debugger 2 includes a trace information decoding unit 21 and an LSI internal information reproducing unit 22.

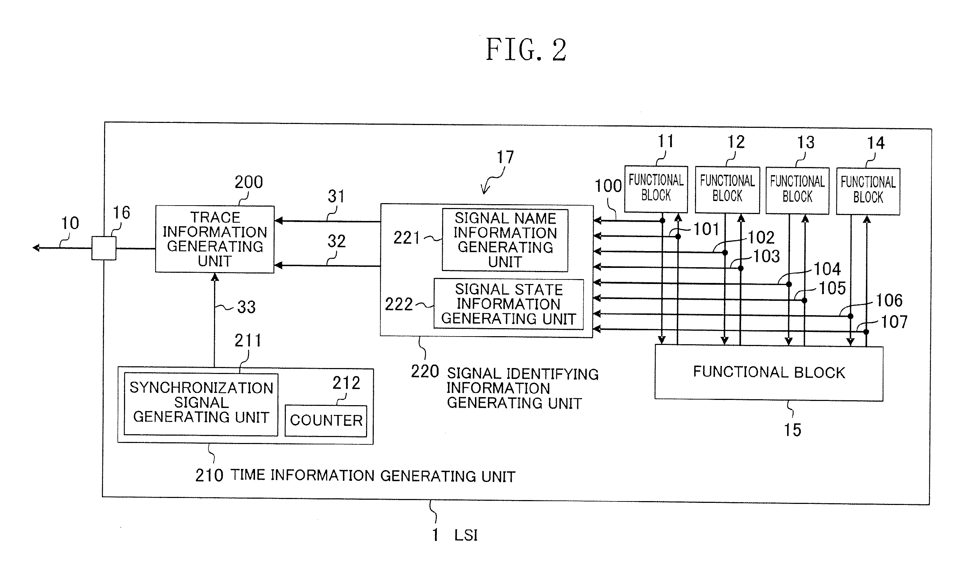

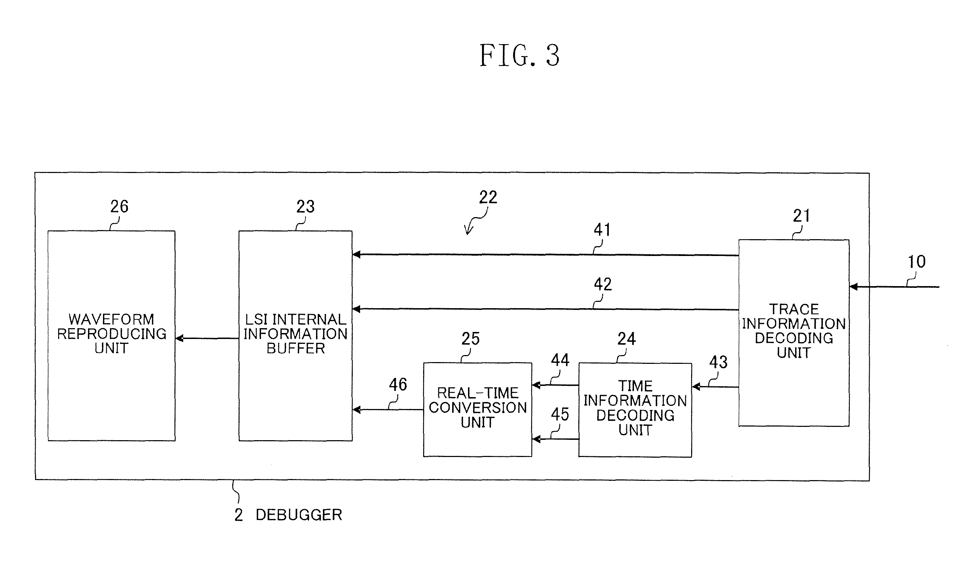

FIGS. 2 and 3 show configurations of the semiconductor device and the development supporting device of the first embodiment of the present invention, respectively.

In the LSI 1 of FIG. 2, a signal identifying information generating unit 220, which has a signal name information generating unit 221 and a signal state information generating unit 222, traces the internal signals 100 to 107 between the functional blocks 11 to 14 and the functional block 15 to detect when a traced signal undergoes a state transition, and generates signal name information 31 and signal state information 32. A time information generating unit 210 has a synchronization signal generating unit 211 and an internal counter 212. The synchronization signal generating unit 211 operates to synchronize the LSI 1 and the externally connected debugger 2, and generates a synchronization signal when synchronization is established. The synchronization signal and the value of the counter 212 are assumed to form time information 33. A trace information generating unit 200, when detecting the signal name information 31 and the signal state information 32, uses the time information 33 at the time to packetize the information 31 to 33 to generate and output the trace information 10.

On the other hand, the debugger 2 of FIG. 3, when detecting the trace information 10, uses the trace information decoding unit 21 to separate signal name information 41, signal state information 42 and time information 43. A time information encoding unit 24 separates the time information 43 into synchronization information 44 and LSI internal time information 45. A real-time conversion unit 25 counts the number of times of synchronization, and converts the number of times of synchronization and the LSI internal time information 45 into real-time information 46. The signal name information 41, the signal state information 42, and the real-time information 46 are stored into an LSI internal information buffer 23. A waveform reproducing unit 26 reproduces LSI internal information based on the information 41, 42 and 46 read out from the LSI internal information buffer 23.

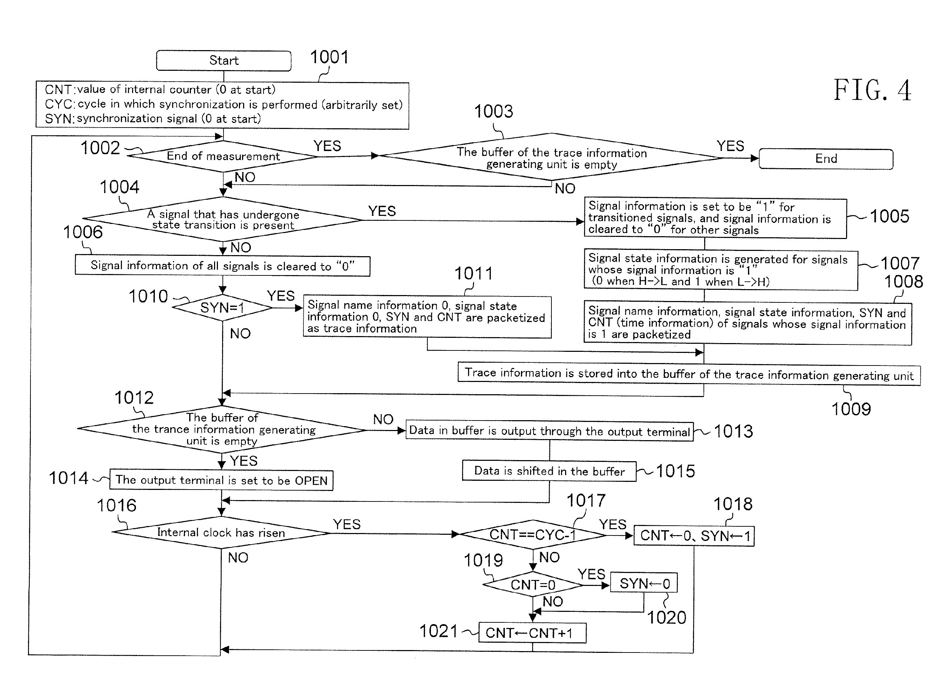

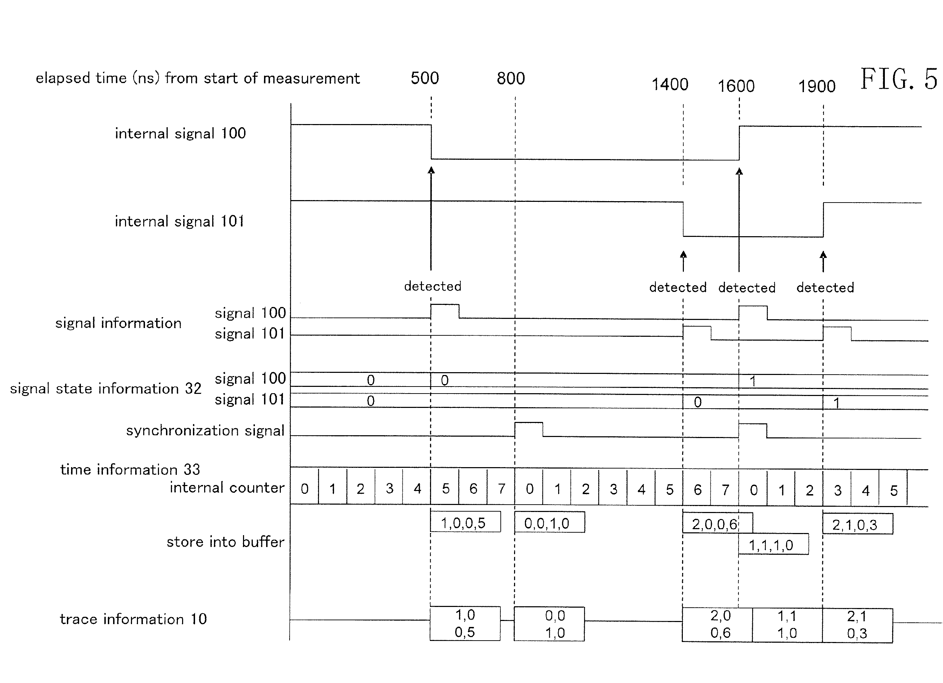

A process of detection of a state transition of an internal signal, and generation of the trace information 10 by an algorithm shown in FIG. 4, in the LSI 1 will be described with reference to a waveform shown in FIG. 5.

In FIG. 5, the internal signal 100 is initially at H, goes to L at 500 ns from the start of measurement, and goes to H at 1600 ns. The internal signal 101 is initially at H, goes to L at 1400 ns from the start of the measurement, and goes to H at 1900 ns. The internal signals 102 to 107 are assumed not to undergo a state transition during the measurement. A time required to output a set of trace information is assumed to be 250 ns. An internal clock for operating the internal counter 212 of the LSI 1 has a cycle of 100 ns. A cycle CYC during which synchronization of the LSI 1 and the debugger 2 is performed is "8".

As can be seen from FIG. 4, during the start of the measurement, a value CNT of the internal counter and a synchronization signal SYN are set to be "0" in step 1001, and control proceeds to step 1002. In step 1002, it is checked whether the measurement is to be ended. When the measurement is to be ended, control proceeds to step 1003, and when the measurement is not to be ended, the process goes to step 1004. In step 1003, it is determined whether a buffer of the trace information generating unit 200 is empty. When the buffer is empty, the flow is ended, and when the buffer is not empty, control proceeds to step 1004. In step 1004, the states of the internal signals 100 to 107 are checked. At 500 ns, 1400 ns, 1600 ns and 1900 ns, since a signal that has undergone a state transition is present, control proceeds to step 1005 so as to generate the trace information 10. In other cases, since no signal that has undergone a state transition is present, control proceeds to step 1006. In step 1005, for a signal that has undergone a state transition, i.e., the signal 100 at 500 ns and 1600 ns, and the signal 101 at 1400 ns and 1900 ns, signal information is set to be "1", and for the other signals, signal information is set to be "0", and control proceeds to step 1007. In step 1007, for a signal that has undergone a state transition, i.e., the signal 100 at 500 ns and 1600 ns, and the signal 101 at 1400 ns and 1900 ns, signal state information 32 is set to be "0" when the signal goes from H to L and "1" when the signal goes from L to H, and control proceeds to step 1008. In step 1008, from the signal information about the signal that has undergone a state transition, the signal name information 31 indicating a signal name ("1" for the signal 100, "2" for the signal 101, ..., and "8" for the signal 107) is generated, and is packetized as trace information using the time information 33 including the signal state information 32, SYN and CNT. At 500 ns, since the signal information about the signal 100 is "1", "1, 0, 0, 5" is packetized. At 1400 ns, since the signal information about the signal 101 is "1", "2, 0, 0, 6" is packetized. At 1600 ns, the signal information about the signal 100 is "1", "1, 1, 1, 0" is packetized. At 1900 ns, since the signal information about the signal 101 1 is "1", "2, 1, 0, 3" is packetized. Control proceeds to step 1009. In step 1009, the packetized trace information is stored in the buffer of the trace information generating unit 200, and control proceeds to step 1012.

In step 1006, the signal information of all the signals is set to be "0", and control proceeds to step 1010. In step 1010, the state of SYN is checked. At 800 ns, since SYN is "1", control proceeds to step 1011 so as to generate trace information when a synchronization signal is generated and a signal state transition does not occur. In other cases, since SYN is "0", control proceeds to step 1012. In step 1011, at 800 ns, trace information "0, 0, 1, 0" when a synchronization signal is generated and a signal state transition does not occur is generated and packetized, and control proceeds to step 1009.

In step 1012, when information remains in the buffer of the trace information generating unit 200, control proceeds to step 1013 so as to output information from the buffer, and when the buffer is empty, control proceeds to step 1014. In step 1013, information in the buffer is output as the trace information 10 through the output terminal 16, and control proceeds to step 1015. In step 1015, the output data is erased from the buffer, and control proceeds to step 1016 so as to shift data that has not yet been output in the buffer and output the data. In step 1014, the output terminal 16 is set to be "OPEN" as a setting for a case when the trace information 10 is not output, and control proceeds to step 1016.

In step 1016, the rising of the internal clock is checked. When the internal clock has risen, control proceeds to step 1017 so as to operate the internal counter 212. When the internal clock has not risen, control proceeds to step 1002. In step 1017, it is checked whether CNT is equal to a value that is obtained by subtracting one from CYC. At 800 ns and 1600 ns, since CNT is 7 that is obtained by subtracting one from 8 that is set in CYC, control proceeds to step 1018 so as to generate the synchronization signal SYN. When CNT is not equal to the value that is obtained by subtracting one from CYC, control proceeds to step 1019. In step 1018, at 800 ns and 1600 ns, the synchronization signal SYN is set to be "1", and CNT is cleared to "0", and control proceeds to step 1002. In step 1019, it is checked whether CNT is "0". At 900 ns and 1700 ns, since CNT is "0", control proceeds to step 1020 so as to clear SYN and increment CNT, and when CNT is not "0", control proceeds to step 1021 so as to simply increment CNT. In step 1020, at 900 ns and 1700 ns, SYN is set to be "0", and control proceeds to step 1021 so as to increment CNT. In step 1021, CNT is incremented by 1, and control proceeds to step 1002.

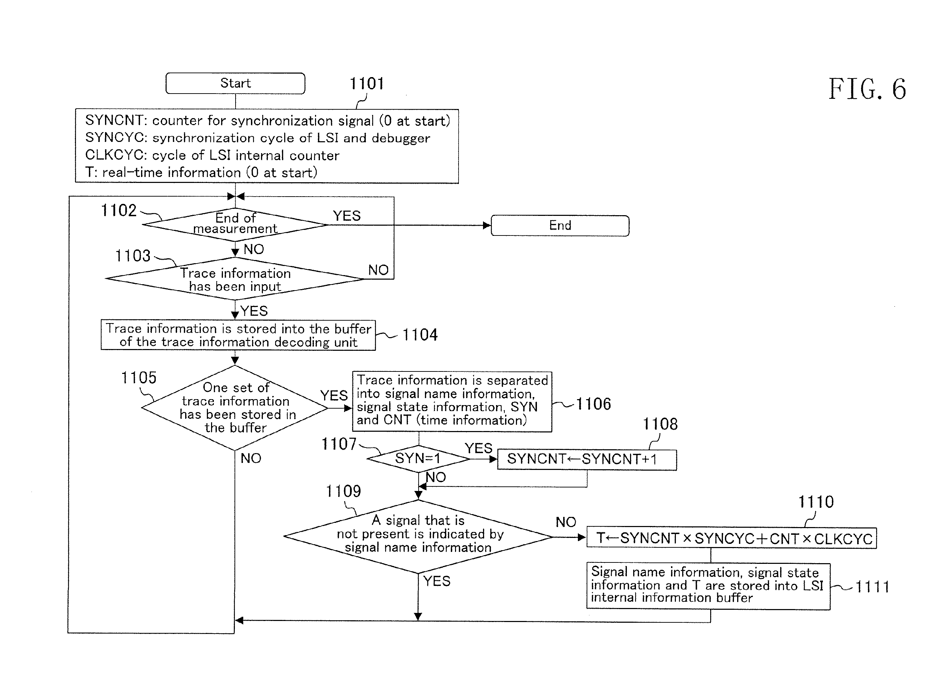

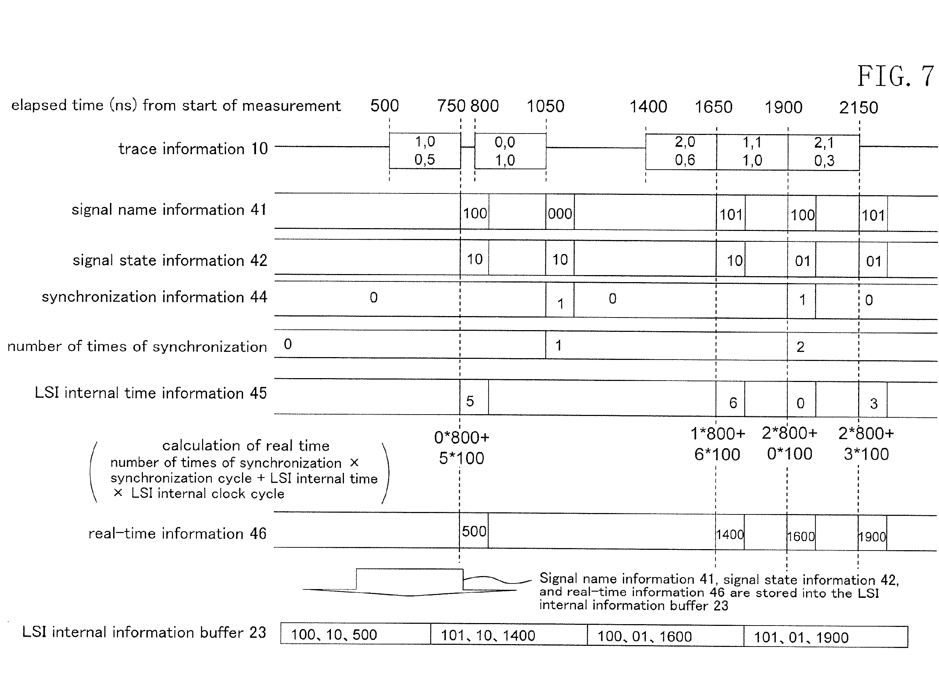

Next, a process of decoding of the trace information 10 by an algorithm shown in FIG. 6 that is performed by the debugger 2 will be described with reference to a waveform diagram shown in FIG. 7.

Before the start of measurement, a cycle SYNCYC in which synchronization of the LSI 1 and the debugger 2 is performed, and a cycle CLKCYC of the LSI internal counter 212 are set. In FIG. 7, SYNCYC is set to be 800 ns and CLKCYC is set to be 100 ns in accordance with the behavior of the LSI 1. An input period of the trace information 10 is assumed to be 250 ns.

During the start of the measurement, in step 1101, the counter SYNCNT of the synchronization signal and real-time information T are set to be "0", and control proceeds to step 1102. In step 1102, it is checked whether the measurement is to be ended. When the measurement is to be ended, the flow is ended, and when the measurement is not to be ended, control proceeds to step 1103. In step 1103, it is checked whether the input of the trace information 10 is present. When the trace information 10 is input, control proceeds to step 1104, and when the trace information 10 is not input, control proceeds to step 1102. In step 1104, the input trace information 10 is stored into the buffer of the trace information decoding unit 21, and control proceeds to step 1105. In step 1105, it is checked whether one set of trace information 10 has been stored in the buffer. At 750 ns, 1050 ns, 1650 ns, 1900 ns and 2150 ns, one set of trace information 10 is stored into the buffer, and control proceeds to step 1106. Otherwise, control proceeds to step 1102. In step 1106, the trace information 10 stored in the buffer is decoded. Specifically, information about a signal name is caused to correspond to the signal name, i.e., "1" is decoded into "100" indicating the signal 100, "2" is decoded into "101" indicating the signal 101, and "0" is decoded into "000" which has no corresponding signal, and these signal names are output as the signal name information 41. Information about a signal state is caused to correspond to the signal state, i.e., "0" is decoded into "10" indicating a signal transition H->L, and "1" is decoded into "01" indicating a signal transition L->H, and these signal states are output as the signal state information 42. Information about time information is separated into synchronization information (SYN) 44 and LSI internal time information (CNT) 45, and control proceeds to step 1107.

In step 1107, the value of SYN obtained from the trace information 10 is checked. At 1050 ns and 1900 ns, since SYN is "1", control proceeds to step 1108 so as to increment the counter SYNCNT for the synchronization signal. In other cases, since SYN is "0", control proceeds to step 1109. In step 1108, SYNCNT is incremented by 1, and control proceeds to step 1109.

In step 1109, it is checked whether a signal indicated by the signal name information is present. Here, at 1050 ns, since the signal name information is "000", i.e., no signal name is assigned to the information, the information is determined to be trace information indicating the occurrence of synchronization, but not information about an LSI internal signal, so that LSI internal information is not generated and control proceeds to step 1102. At 750 ns, 1650 ns, 1900 ns and 2150 ns, control proceeds to step 1110 so as to generate LSI internal information.

In step 1110, the real-time information T about the occurrence of signal transition is calculated based on the counter SYNCNT for the synchronization signal, the cycle SYNCYC (800 ns) for synchronization, the cycle CLKCYC (100 ns) for the LSI internal counter 212, and CNT obtained from the trace information. At 750 ns, since the decoded CNT is "5" and SYNCNT is "0", T is 500 (ns). At 1650 ns, since the decoded CNT is "6" and SYNCNT is "1", T is 1400 (ns). At 1900 ns, since the decoded CNT is "0" and SYNCNT is "2", T is 1600 (ns). At 2150 ns, since the decoded CNT is "3" and SYNCNT is "2", T is 1900 (ns). The generated T is output as the real-time information 46, and control proceeds to step 1111. In step 1111, the decoded signal name information 41, signal state information 42 and real-time information 46 are stored into the LSI internal information buffer 23. At 750 ns, "100, 10, 500" is stored into the LSI internal information buffer 23. At 1650 ns, "101, 10, 1400" is stored into the LSI internal information buffer 23. At 1900 ns, "100, 01, 1600" is stored into the LSI internal information buffer 23. At 2150 ns, "101, 01, 1900" is stored into the LSI internal information buffer 23.

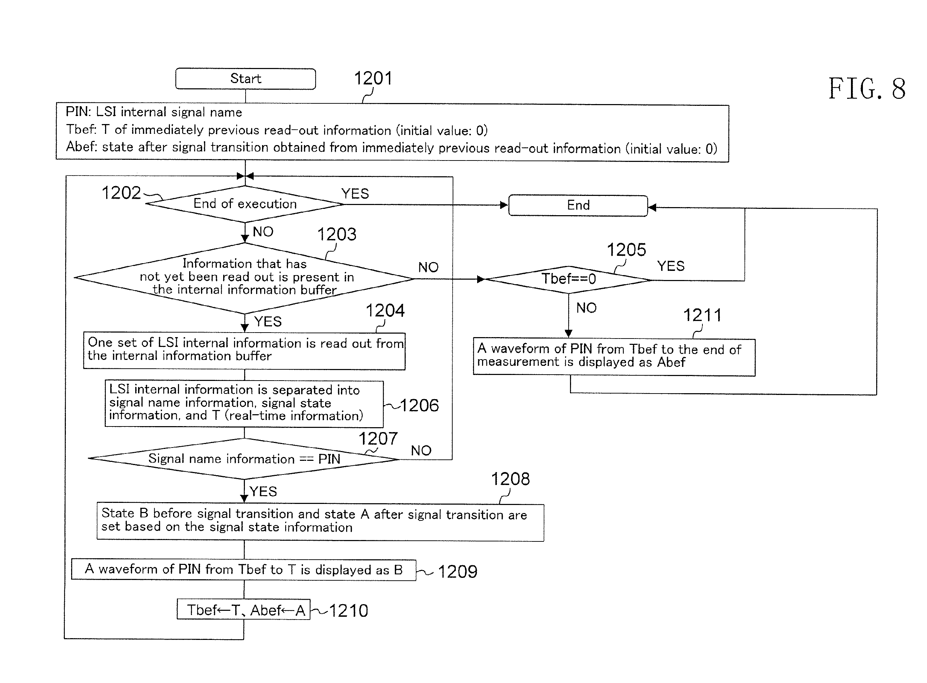

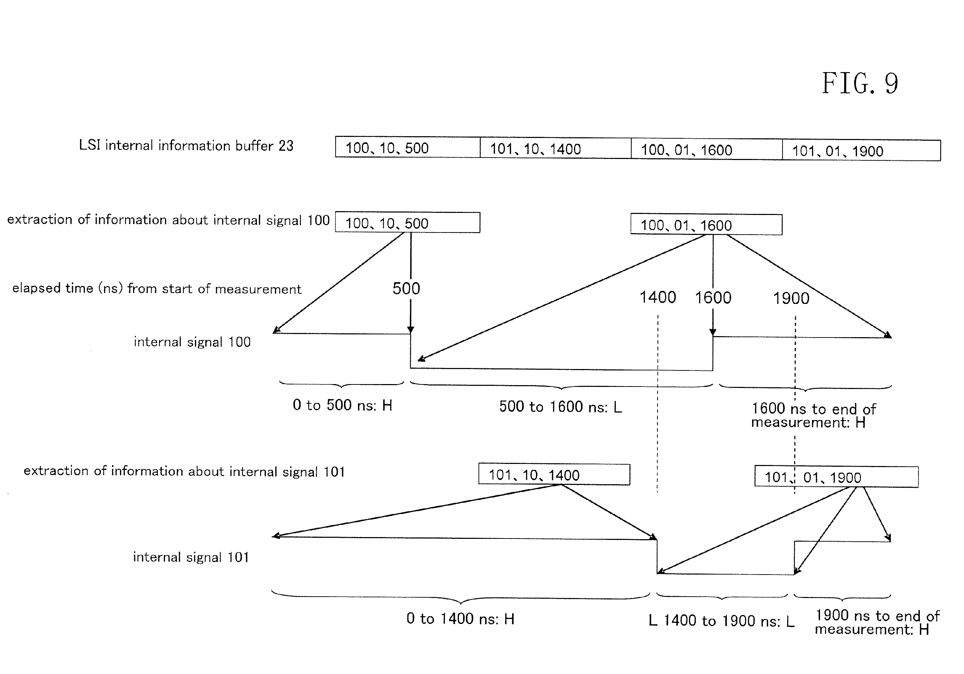

Next, a process of decoding of information by an algorithm shown in FIG. 8 so as to reproduce a waveform of an LSI internal signal will be described with reference to a waveform diagram shown in FIG. 9.

Initially, a signal name for which a waveform is to be reproduced is designated as "100". The designated signal name "100" is set into PIN.

During the start of reproduction, in step 1201, Tbef is set to be 0 (ns) and Abef is set to be "0", and control proceeds to step 1202. In step 1202, it is checked whether the reproduction is to be ended. When the reproduction is to be ended, the flow is ended. When the reproduction is not to be ended, control proceeds to step 1203. In step 1203, it is checked whether information that has not yet been read out is present in the LSI internal information buffer 23. Since four sets of information are present in the LSI internal information buffer 23, i.e., the four sets of information have not yet been read out, control proceeds to step 1204. After the four sets of information have read out, there is no information that has not yet been read out, so that control proceeds to step 1205.

In step 1204, one set of information is read out from the internal information buffer 23, and control proceeds to step 1206. In step 1206, the read-out LSI internal information is separated into signal name information, signal state information, and T (real-time information), and control proceeds to step 1207. For example, in the case of "100, 10, 500", the signal name information is "100", the signal state information is "10", and T is "500". In step 1207, it is checked whether the separated signal name information matches PIN. The read-out information includes four sets, i.e., "100, 10, 500", "101, 10, 1400", "100, 01, 1600", and "101, 01, 1900" in this stated order. Here, when "100, 10, 500" and "100, 01, 1600" are read out, since the signal name information matches "100" set in PIN, control proceeds to step 1208. When "101, 10, 1400" and "101, 01, 1900" are read out, since the signal name information does not match "100" set in PIN, control proceeds to step 1202. In step 1208, from the signal state information, a state B before a signal transition and a state A after the signal transition are set. When the signal state information is "10", B is set to be "H" and A is set to be "L", and when the signal state information is "01", B is set to be "L" and A is set to be "H", and control proceeds to step 1209. In step 1209, the LSI internal information is reproduced. Specifically, when "100, 10, 500" is read out, since Tbef is 0, a waveform of the signal 100 representing "H" indicated by B from Tbef (0 ns) to T (500 ns) is displayed. When " 100, 01, 1600" is read out, since Tbef is 500, a waveform of the signal 100 representing "L" indicated by B from Tbef (500 ns) to T (1600 ns) is displayed. Control proceeds to step 1210. In step 1210, T is written into Tbef and A is written into Abef, and control proceeds to step 1202.

In step 1205, a process for ending a waveform reproduction process is performed. When control proceeds to step 1205, since Tbef is 1600, control proceeds to step 1211. In step 1211, a waveform of a portion that has not yet been displayed is displayed. Specifically, "H" indicated by Abef is displayed from Tbef (1600 ns) to the end of the measurement, and the reproduction is ended.

By the flow described above, the measured waveform of the signal 100 of FIG. 5 is reproduced as follows. "H" is displayed from the start of the measurement to 500 ns, "L" is displayed from 500 ns to 1600 ns, and "H" is displayed after 1600 ns.

Next, when a signal name for which a waveform is to be reproduced is assumed to be "101", "H" is displayed from the start of the measurement to 1400 ns, "L" is displayed from 1400 ns to 1900 ns, and "H" is displayed after 1900 ns in accordance with a similar flow.

Also, when a signal name for which a waveform is to be reproduced is assumed to be any of "102" to "107", since information that matches a signal to be reproduced is not present until the end of reading out of data, the initial value of Tbef remains "0" in step 1205, so that the waveform is not displayed and the flow is ended, in accordance with a similar flow.

### «Second Embodiment»

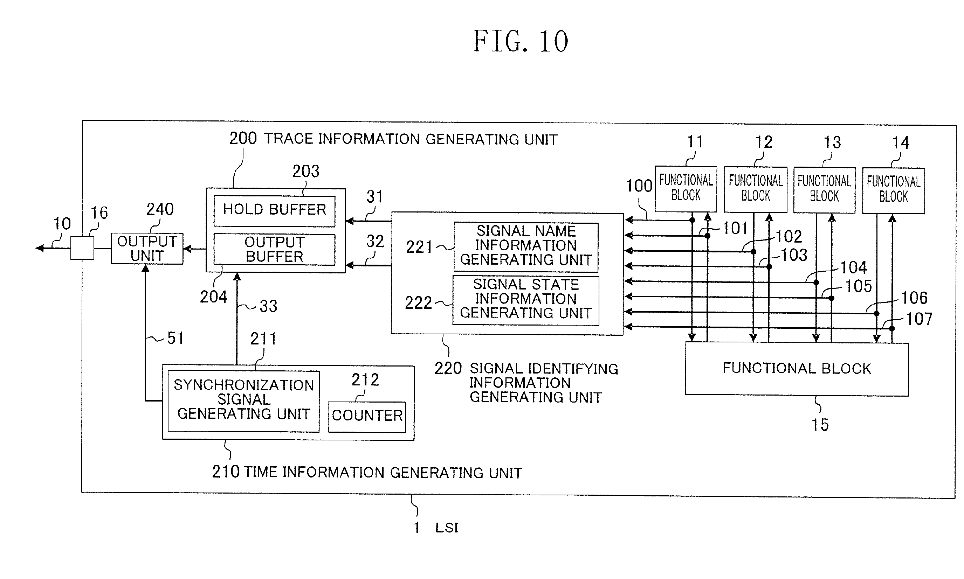

FIG. 10 is a block diagram showing a configuration of a semiconductor device according to a second embodiment of the present invention. It has been assumed in the semiconductor device of the first embodiment that the trace information 10 is output to the outside every time a signal transition is detected, or every time synchronization is performed. In the second embodiment, generated trace information is accumulated in a hold buffer 203 of a trace information generating unit 200, and the information in the hold buffer 203 is moved to an output buffer 204 and is output as trace information 10 from the output buffer 204 in accordance with a synchronization signal 51 output by a time information generating unit 210.

In the second embodiment, a debugger 2 can know the number of synchronization signals corresponding to input trace information 10, and therefore, the output of trace information indicating a synchronization signal is not required, so that the data amount of output information can be reduced. Also, trace information can be merged when the same signal undergoes a state transition a plurality of times during the same measurement cycle, thereby removing the signal name, so that the data amount of output information can be reduced.

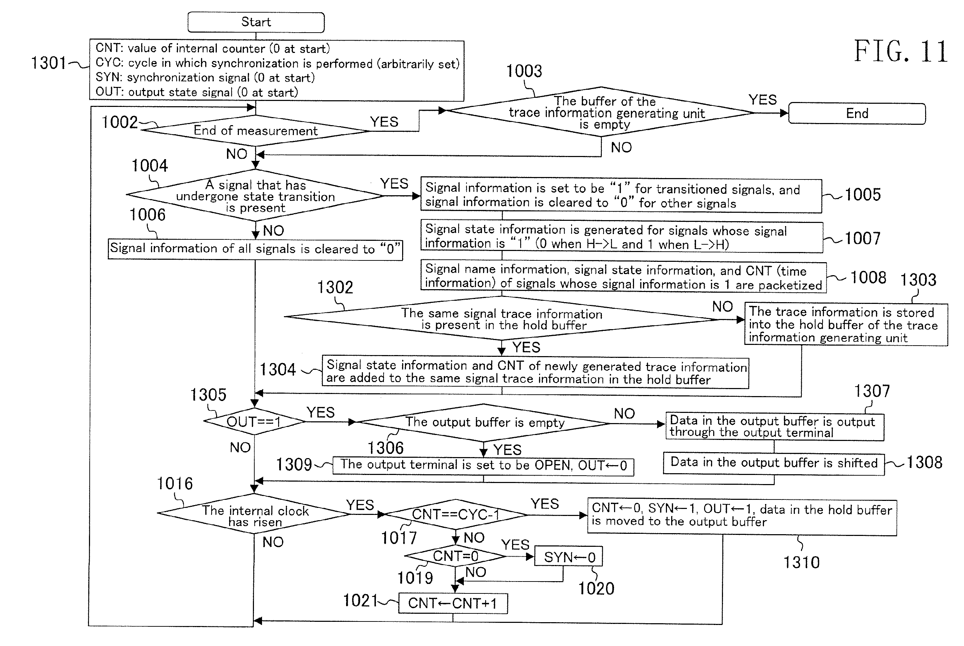

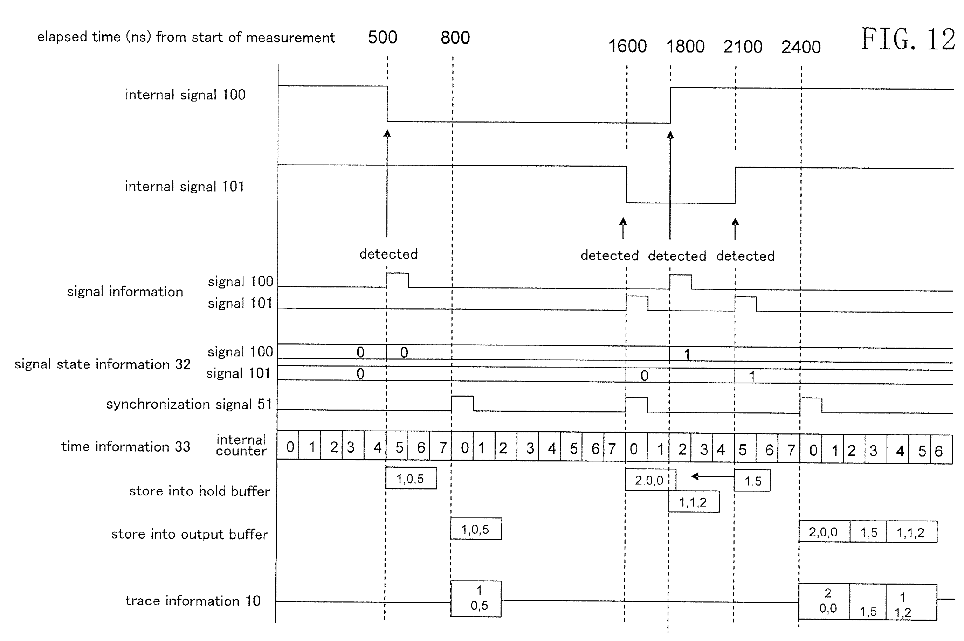

In the second embodiment of the present invention, a process of detection of a state transition of an internal signal, and generation of the trace information 10 by an algorithm shown in FIG. 11, will be described with reference to a waveform diagram shown in FIG. 12.

In FIG. 12, an internal signal 100 is initially at H, goes to L at 500 ns from the start of measurement, and goes to H at 1800 ns. An internal signal 101 is initially at H, goes to L at 1600 ns from the start of the measurement, and goes to H at 2100 ns. Internal signals 102 to 107 are assumed not to undergo a state transition during the measurement. An internal clock for operating an internal counter 212 of an LSI 1 has a cycle of 100 ns, and a cycle CYC during which synchronization of the LSI 1 and the debugger 2 is performed is set to be "8".

During the start of the measurement, in step 1301, the value CNT of the internal counter 212, a synchronization signal SYN, and an output state signal OUT are set to be "0", and control proceeds to step 1002. In step 1002, it is checked whether the measurement is to be ended. When the measurement is to be ended, control proceeds to step 1003, and when the measurement is not to be ended, control proceeds to step 1004. In step 1003, it is determined whether the output buffer 204 of the trace information generating unit 200 is empty. When the output buffer 204 is empty, the flow is ended. When the output buffer 204 is not empty, control proceeds to step 1004. In step 1004, the states of the internal signals 100 to 107 are checked. At 500 ns, 1600 ns, 1800 ns and 2100 ns, since a signal that has undergone a state transition is present, control proceeds to step 1005 so as to generate trace information. In other cases, since no signal that has undergone a state transition is present, control proceeds to step 1006. In step 1005, for a signal that has undergone a state transition, i.e., the signal 100 at 500 ns and 1800 ns and the signal 101 at 1600 ns and 2100 ns, signal information is set to be "1", and for the other signals, signal information is set to be "0", and control proceeds to step 1007. In step 1007, for a signal that has undergone a state transition, i.e., the signal 100 at 500 ns and 1800 ns and the signal 101 at 1600 ns and 2100 ns, signal state information 32 is set to be "0" when the signal has gone from H to L, and "1" when the signal has gone from L to H, and control proceeds to step 1008. In step 1008, signal name information 31 indicating a signal name ("1" for the signal 100, "2" for the signal 101, ..., and "8" for the signal 107) is generated from signal information about a signal that has undergone a state transition, and is packetized as trace information using the signal state information 32, and time information 33 including only CNT. At 500 ns, since the signal information about the signal 100 is "1", "1, 0, 5" is packetized. At 1600 ns, since the signal information about the signal 101 is "1", "2, 0, 0", is packetized. At 1800 ns, since the signal information about the signal 100 is "1", "1, 1, 2" is packetized. At 2100 ns, since the signal information about the signal 101 1 is "1", "2, 1, 5" is packetized. Control proceeds to step 1302. In step 1302, it is checked whether signal trace information accumulated in the hold buffer 203 includes the same signal information as that which has been packetized in step 1008. At 2100 ns, the same trace information about the signal 101 that was generated at 1600 ns is present in the hold buffer 203, control proceeds to step 1304 so as to merge the information. At 500 ns, 1600 ns and 1800 ns, since the same signal trace information is not present in the hold buffer 203, control proceeds to step 1303. In step 1303, the packetized trace information is stored into the hold buffer 203, and control proceeds to step 1305. In step 1304, signal state information and CNT of the generated trace information are added to the same signal trace information present in the hold buffer 203. At 2100 ns, "1, 5" corresponding to the signal state information and CNT of the generated trace information "2, 1, 5" are added to the trace information "2, 0, 0" that is already present in the hold buffer 203, and control proceeds to step 1304.

In step 1006, signal information of all signals is set to be "0", and control proceeds to step 1305. In step 1305, the value of the output state signal OUT is checked. When the trace information 10 is output, OUT is "1", so that control proceeds to step 1306. When the trace information 10 is not output, OUT is "0", so that control proceeds to step 1016. In step 1306, it is checked whether the output buffer 204 is empty. When the trace information 10 has been completely output, control proceeds to step 1309 so as to change OUT from "1" to "0". When the trace information 10 has not been completely output, control proceeds to step 1307 so as to output the trace information 10. In step 1307, information in the output buffer 204 is output as the trace information 10 through an output terminal 16, and control proceeds to step 1308. In step 1308, the output data is erased from the output buffer 204, and control proceeds to step 1016 so as to shift data that has not yet been output in the output buffer 204 and output the data. In step 1309, the output terminal 16 is set to be OPEN as a setting for a case when the trace information 10 is not output, and OUT is set to be "0" (a state in which the trace information 10 is not output), and control proceeds to step 1016.

In step 1016, the rising of the internal clock is checked. When the internal clock has risen, control proceeds to step 1017 so as to operate the internal counter 212. When the internal clock has not risen, control proceeds to step 1002. In step 1017, it is checked whether CNT is equal to a value that is obtained by subtracting one from CYC. At 800 ns and 1600 ns, since CNT is 7 that is obtained by subtracting one from 8 that is set in CYC, control proceeds to step 1310 so as to generate the synchronization signal SYN. When CNT is not equal to the value that is obtained by subtracting one from CYC, control proceeds to step 1019. In step 1310, at 800 ns and 1600 ns, the synchronization signal SYN is set to be "1", CNT is cleared to "0", the output state signal OUT is set to be "1" (i.e., an output state is set), and data accumulated in the hold buffer 203 is moved to the output buffer 204, and control proceeds to step 1002. In step 1019, it is checked whether CNT is "0". At 900 ns and 1700 ns, since CNT is "0", control proceeds to step 1020 so as to clear SYN and increment CNT, and when CNT is not "0", control proceeds to step 1021 so as to simply increment CNT. In step 1020, at 900 ns and 1700 ns, SYN is set to be "0", and control proceeds to step 1021 so as to increment CNT. In step 1021, CNT is incremented by 1, and control proceeds to step 1002.

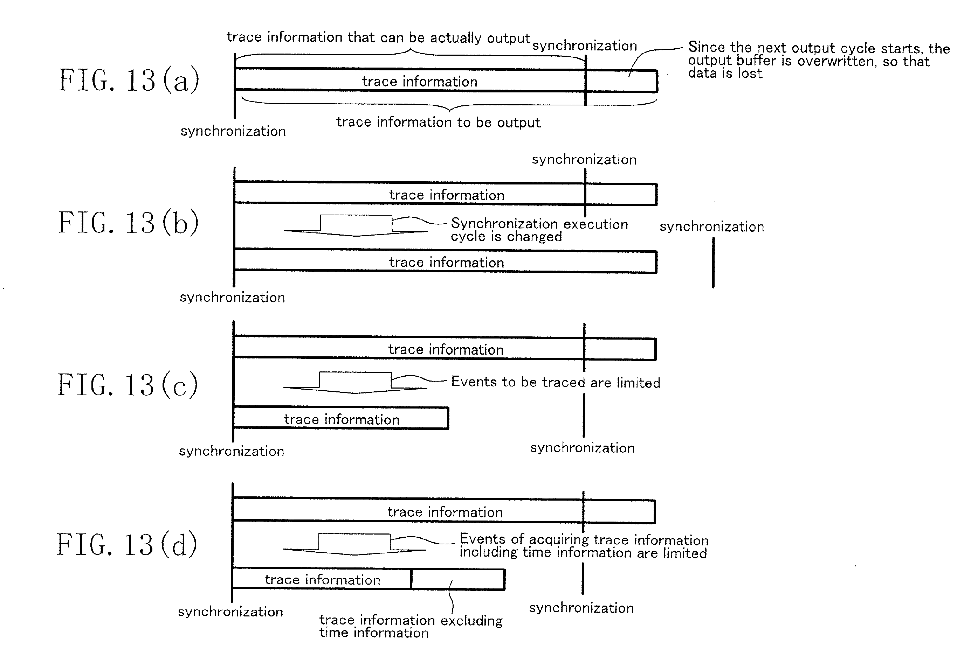

When trace information is accumulated in the hold buffer 203 of the trace information generating unit 200, and the trace information 10 is output from the output buffer 204 to the outside in accordance with the synchronization signal 51 as described above, then if the data amount of the trace information 10 during one output period is large, so that the next synchronization signal 51 occurs before all information accumulated in the output buffer 204 is output as shown in FIG. 13(a), the output buffer 204 is overwritten with data in the hold buffer 203, and therefore, data remaining in the output buffer 204 at the time may be lost, so that the debugger 2 may fail to acquire the complete trace information 10.

Means for avoiding such a loss of trace information is shown in FIGS. 13(b) to 13(d). Initially, as shown in FIG. 13(b), synchronization timing is temporarily postponed, thereby preventing the occurrence of the next synchronization signal during the output of trace information. As shown in FIG. 13(c), an event to be traced is limited to reduce the amount of output information so that the output of trace information can be completed by the time when the next synchronization signal occurs. As shown in FIG. 13(d), an event of acquiring trace information excluding time information is separated from an event of acquiring trace information including time information, thereby reducing the amount of output information so that the output of trace information can be completed by the time when the next synchronization signal occurs.

Next, specific examples of the trace information loss avoiding means of FIGS. 13(b) to 13(d) will be described as third to fifth embodiments.

### «Third Embodiment»

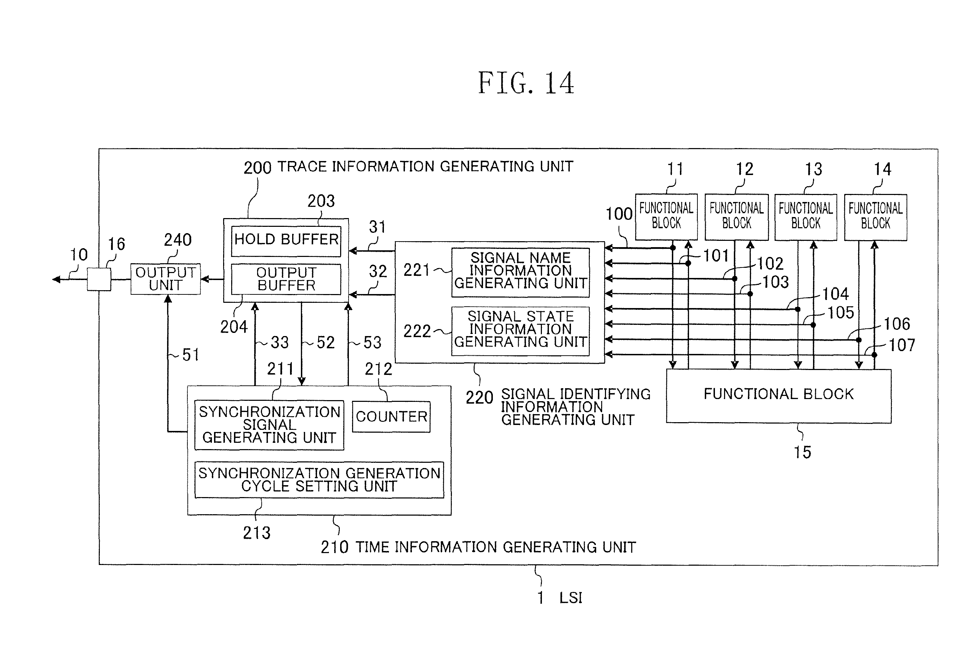

FIG. 14 is a block diagram showing a configuration of a semiconductor device according to a third embodiment of the present invention. In the third embodiment, a synchronization occurrence cycle setting unit 213 is provided in a time information generating unit 210 so that a cycle in which synchronization is performed is extended as shown in FIG. 13(b), thereby preventing the occurrence of the next synchronization signal 51 during the output of trace information 10.

Also, the synchronization cycle can be changed to a preset value based on the data amount 52 of the trace information. For example, when the initial value of the synchronization cycle CYC is 800 ns, 1200 ns is previously set into NCYC, and when trace information that is not output is accumulated during the 800 ns, the synchronization cycle CYC is changed to 1200 ns. After the cycle during which synchronization is performed is changed, information 53 indicating the change of the synchronization cycle is output together with the trace information 10 when the next synchronization signal 51 is generated.

According to this embodiment, the synchronization cycle can be automatically changed based on the data amount, so that when a loss of data is confirmed, it is no longer necessary to execute measurement again after resetting the synchronization cycle.

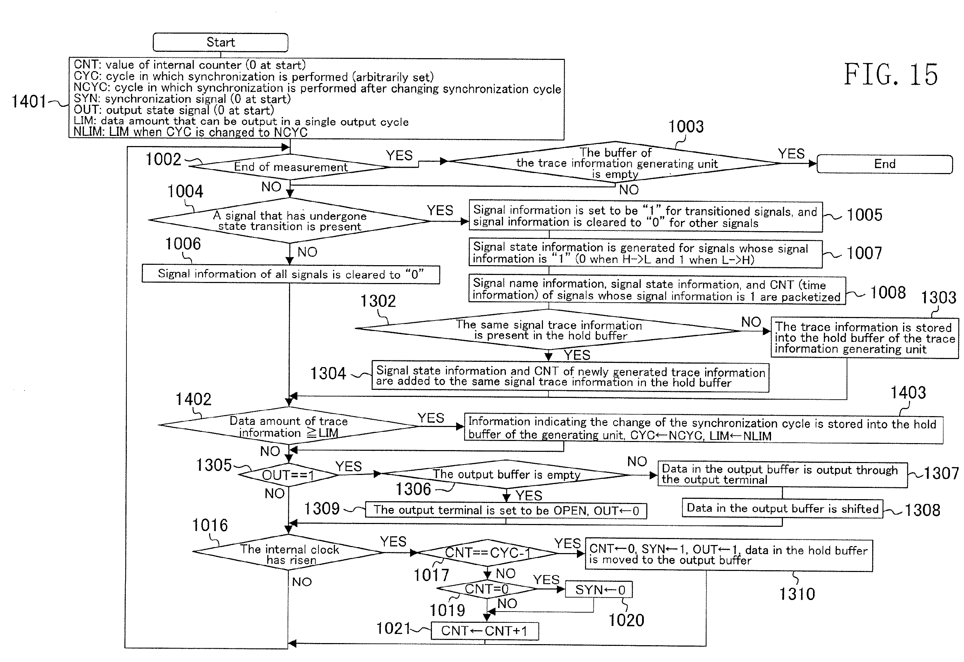

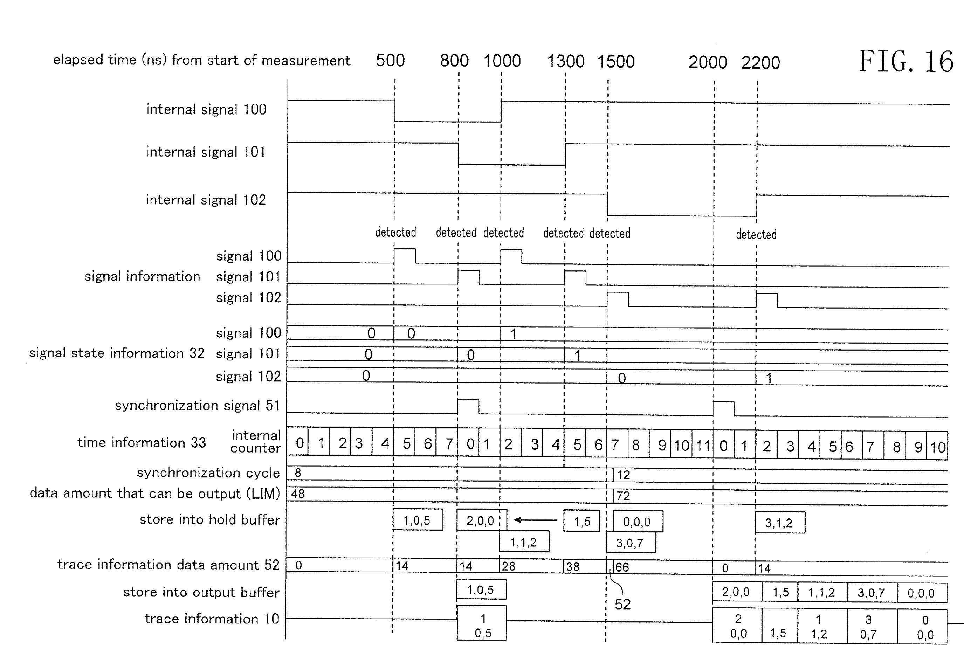

In the third embodiment of the present invention, a process of detection of a state transition of an internal signal, and generation of the trace information 10 in accordance with an algorithm shown in FIG. 15 will be described with reference to a waveform diagram shown in FIG. 16.

In FIG. 16, the internal signal 100 is initially at H, goes to L at 500 ns from the start of measurement, and goes to H at 1000 ns. The internal signal 101 is initially at H, goes to L at 800 ns from the start of the measurement, and goes to H at 1300 ns. The internal signal 102 is initially at H, goes to L at 1500 ns from the start of the measurement, and goes to H at 2200 ns. The internal signals 103 to 107 are assumed not to undergo a state transition during the measurement. An internal clock for operating the internal counter 212 of the LSI 1 has a cycle of 100 ns, and a cycle CYC in which the LSI 1 and the debugger 2 are synchronized is set to be "8". A cycle NCYC in which synchronization is performed after the synchronization cycle is changed is set to be "12" as an initial value. A data amount LIM that can be output in a single output cycle is set to be "48" as an initial value. A data amount NLIM that can be output in a single output cycle after the synchronization cycle is changed is set to be "72" as an initial value. The unit of LIM and NLIM is assumed to be bit. The data amount of a set of trace information is assumed to be 14 bits. A data amount that is added upon merger is assumed to be 10 bits.

During the start of the measurement, in step 1401, the value CNT of the internal counter 212, the synchronization signal SYN, and the output state signal OUT are set to be "0", and control proceeds to step 1002. In step 1002, it is checked whether the measurement is to be ended. When the measurement is to be ended, control proceeds to step 1003, and when the measurement is not to be ended, control proceeds to step 1004. In step 1003, it is determined whether the output buffer 204 of the trace information generating unit 200 is empty. When the output buffer 204 is empty, the flow is ended. When the output buffer 204 is not empty, control proceeds to step 1004. In step 1004, the states of the internal signals 100 to 107 are checked. At 500 ns, 800 ns, 1000 ns, 1300 ns, 1500 ns and 2200 ns, since a signal that has undergone a state transition is present, control proceeds to step 1005 so as to generate trace information. In other cases, since no signal that has undergone a state transition is present, control proceeds to step 1006. In step 1005, for a signal that has undergone a state transition, i.e., the signal 100 at 500 ns and 1000 ns, the signal 101 at 800 ns and 1300 ns, the signal 102 at 1500 ns and 2200 ns, signal information is set to be "1", and for the other signals, signal information is set to be "0", and control proceeds to step 1007. In step 1007, for a signal that has undergone a state transition, i.e., the signal 100 at 500 ns and 1000 ns, the signal 101 1 at 800 ns and 1300 ns, and the signal 102 at 1500 ns and 2200 ns, signal state information 32 is set to be "0" when the signal has gone from H to L, and "1" when the signal has gone from L to H, and control proceeds to step 1008. In step 1008, signal name information 31 indicating a signal name ("1" for the signal 100, "2" for the signal 101, ..., and "8" for the signal 107) is generated from signal information about a signal that has undergone a state transition, and is packetized as trace information using the signal state information 32, and time information 33 including only CNT. Specifically, at 500 ns, since the signal information about the signal 100 is "1", "1, 0, 5" is packetized. At 800 ns, since the signal information about the signal 101 is "1", "2, 0, 0", is packetized. At 1000 ns, since the signal information about the signal 100 is "1", "1, 1, 2" is packetized. At 1300 ns, since the signal information about the signal 101 is "1", "2, 1, 5" is packetized. At 1500 ns, since the signal information about the signal 102 is "1", "3, 0, 7" is packetized. At 2200 ns, since the signal information about the signal 102 is "1", "3, 1, 2" is packetized. Control proceeds to step 1302. In step 1302, it is checked whether signal trace information accumulated in the hold buffer 203 includes the same signal information as that which has been packetized in step 1008. At 1300 ns, since the same trace information about the signal 101 that was generated at 800 ns is present in the hold buffer 203, control proceeds to step 1304 so as to merge the information. At 500 ns, 800 ns, 1000 ns, 1500 ns and 2200 ns, since the same signal trace information is not present in the hold buffer 203, control proceeds to step 1303. In step 1303, the packetized trace information is stored into the hold buffer 203, and control proceeds to step 1402. In step 1304, signal state information and CNT of the generated trace information are added to the same signal trace information present in the hold buffer 203. Specifically, at 1300 ns, "1, 5" corresponding to the signal state information and CNT of the generated trace information "2, 1, 5" is added to the trace information "2, 0, 0" that is already present in the hold buffer 203, and control proceeds to step 1402.

In step 1006, signal information of all signals is set to be "0", and control proceeds to step 1402. In step 1402, the data amount of the hold buffer 203 is checked based on the trace information data amount 52. At 1500 ns, since the data amount is 52, which is larger than or equal to LIM, control proceeds to step 1403. At times other than 1500 ns, since the data amount is smaller than LIM, control proceeds to step 1305. In step 1403, information about the change of the synchronization cycle is output to the trace information generating unit 200. In response to this, the information "0, 0, 0" about the change of the synchronization cycle is stored into the hold buffer 203, and the time information generating unit 210 updates the synchronization cycle CYC with the value of NCYC, and the data amount LIM that can be output with the value of NLIM, and control proceeds to step 1305.

In step 1305, the value of the output state signal OUT is checked. When the trace information 10 is output, since OUT is "1", control proceeds to step 1306. When the trace information 10 is not output, since OUT is "0", control proceeds to step 1016. In step 1306, it is checked whether the output buffer 204 is empty. When the trace information 10 has been completely output, control proceeds to step 1309 so as to change OUT from "1" to "0". When the trace information 10 has not been completely output, control proceeds to step 1307 so as to output the trace information 10. In step 1307, information in the output buffer 204 is output as the trace information 10 through the output terminal 16, and control proceeds to step 1308. In step 1308, data that has been output is erased from the output buffer 204, and control proceeds to step 1016 so as to shift data that has not yet been output in the output buffer 204 and output the data. In step 1309, the output terminal 16 is set to be OPEN as a setting for a case when the trace information 10 is not output, and OUT is set to be "0" (a state in which the trace information 10 is not output), and control proceeds to step 1016.

In step 1016, the rising of the internal clock is checked. When the internal clock has risen, control proceeds to step 1017 so as to operate the internal counter 212. When the internal clock has not risen, control proceeds to step 1002. In step 1017, it is checked whether CNT is equal to a value that is obtained by subtracting one from CYC. At 800 ns, since CNT is 7 that is obtained by subtracting one from 8 that is set in CYC, and at 2000 ns, since CNT is 11 that is obtained by subtracting one from 12 that is set in CYC, control proceeds to step 1310 so as to generate the synchronization signal SYN. When CNT is not equal to the value that is obtained by subtracting one from CYC, control proceeds to step 1019. In step 1310, at 800 ns and 2000 ns, the synchronization signal SYN is set to be "1", CNT is cleared to "0", the output state signal OUT is set to be "1" (i.e., an output state is set), and data accumulated in the hold buffer 203 is moved to the output buffer 204, and control proceeds to step 1002. In step 1019, it is checked whether CNT is "0". At 900 ns and 2100 ns, since CNT is "0", control proceeds to step 1020 so as to clear SYN and increment CNT, and when CNT is not "0", control proceeds to step 1021 so as to simply increment CNT. In step 1020, at 900 ns and 2100 ns, SYN is set to be "0", and control proceeds to step 1021 so as to increment CNT. In step 1021, CNT is incremented by 1, and control proceeds to step 1002.

### «Fourth Embodiment»

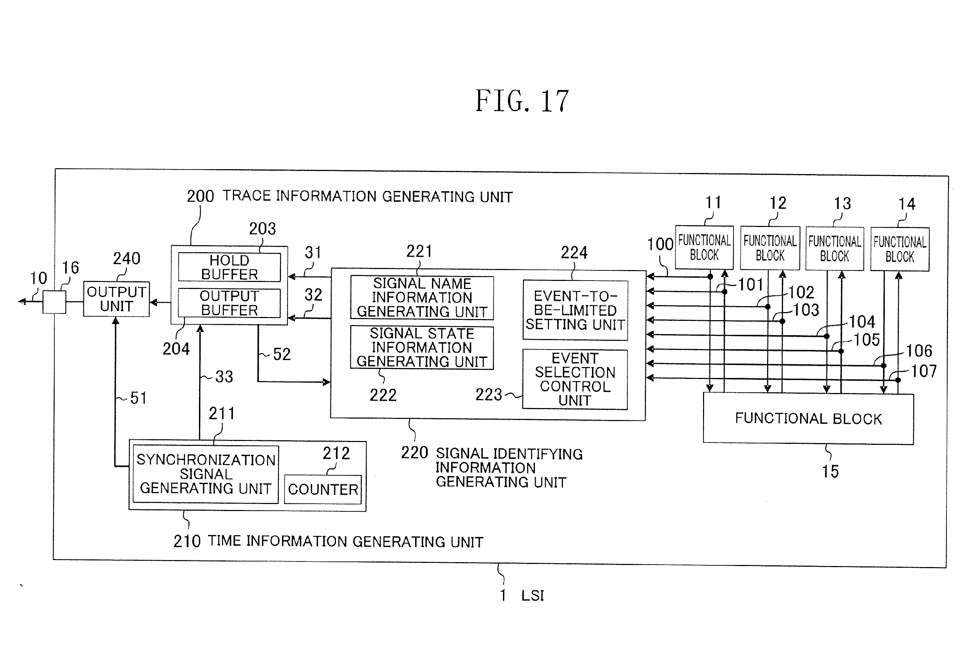

FIG. 17 is a block diagram showing a configuration of a semiconductor device according to a fourth embodiment of the present invention. In the fourth embodiment, an event selection control unit 223 is provided in a signal identifying information generating unit 220. As shown in FIG. 13(c), the event selection control unit 223 limits events that acquire trace information so as to reduce the amount of output information so that the trace information is completely output by the time when the next synchronization signal occurs. This is applied to, for example, a case where it is necessary to investigate a time relationship in signal transition between internal signals 100 to 103, and the priority of acquisition of information about internal signals 104 to 107 is low.

Also, based on a data amount 53 of trace information, it is possible to automatically limit events that acquire trace information. Each event is provided with a priority level for acquisition of trace information, and an event having a low priority level is masked not to allow information acquisition. The priority level can be arbitrarily changed, depending on a setting of an event-to-be-limited setting unit 224.

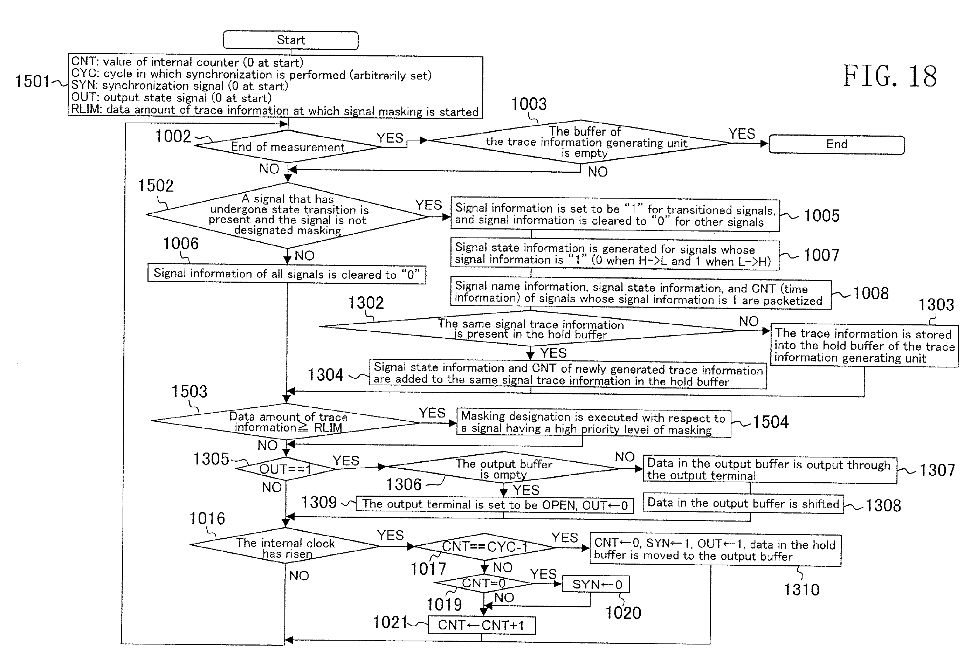

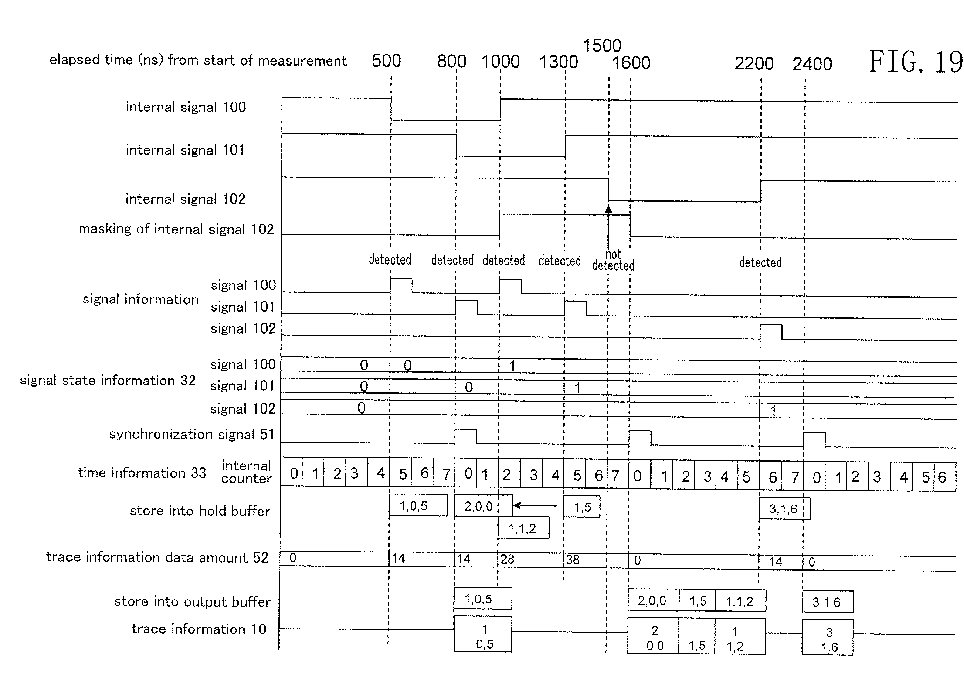

In the fourth embodiment of the present invention, a process of detection of a state transition of an internal signal, and generation of trace information 10 by an algorithm shown in FIG. 18, will be described with reference to a waveform diagram shown in FIG. 19.

In FIG. 19, the internal signal 100 is initially at H, goes to L at 500 ns from the start of measurement, and goes to H at 1000 ns. The internal signal 101 is initially at H, goes to L at 800 ns from the start of the measurement, and goes to H at 1300 ns. The internal signal 102 is initially at H, goes to L at 1500 ns from the start of the measurement, and goes to H at 2200 ns. The internal signals 103 to 107 are assumed not to undergo a state transition during the measurement. An internal clock for operating an internal counter 212 of an LSI 1 has a cycle of 100 ns, and a cycle CYC in which synchronization of the LSI 1 and a debugger 2 is performed is set to be "8". A data amount RLIM of trace information when signal masking is started is set to be "24". The unit of RLIM is bit. The priority level of signal masking is set to be high for the signal 102, and low for the signals 100 and 101. The data amount of one set of trace information is assumed to be 14 bits, and a data amount that is added upon merger is assumed to be 10 bits.

During the start of the measurement, in step 1501, the value CNT of the internal counter 212, the synchronization signal SYN, are the output state signal OUT are set to be "0", and control proceeds to step 1002. In step 1002, it is checked whether the measurement is to be ended. When the measurement is to be ended, control proceeds to step 1003, and when the measurement is not to be ended, control proceeds to step 1502. In step 1003, it is checked whether the output buffer 204 of the trace information generating unit 200 is empty. When the output buffer 204 is empty, the flow is ended, and when the output buffer 204 is not empty, control proceeds to step 1502. In step 1502, the states of the internal signals 100 to 107 are checked. At 500 ns, 800 ns, 1000 ns, 1300 ns, 1500 ns and 2200 ns, a signal that has undergone a state transition is present. At 1500 ns, the signal 102 is masked. Therefore, at 500 ns, 800 ns, 1000 ns, 1300 ns and 2200 ns, control proceeds to step 1005 so as to generate trace information, and in other cases, since no signal that has undergone a state transition is present, or masking is designated, control proceeds to step 1006. In step 1005, for a signal that has undergone a state transition, i.e., the the signal 100 at 500 ns and 1000 ns, the signal 101 at 800 ns and 1300 ns, and the signal 102 at 2200 ns, signal information is set to be "1", and for the other signals, signal information is set to be "0", and control proceeds to step 1007. In step 1007, for a signal that has undergone a state transition, i.e., the signal 100 at 500 ns and 1000 ns, the signal 101 at 800 ns and 1300 ns, and the signal 102 at 2200 ns, signal state information 32 is set to be "0" when the signal has gone from H to L, and "1" when the signal has gone from L to H, and control proceeds to step 1008. In step 1008, from signal information about a signal that has undergone a state transition, signal name information 31 indicating a signal name ("1" for the signal 100, "2" for the signal 101, "3" for the signal 102, ..., and "8" for the signal 107) is generated, and is packetized as trace information using the signal state information 32, and time information 33 including only CNT. Specifically, at 500 ns, since signal information about the signal 100 is "1", "1, 0, 5" is packetized. At 800 ns, since signal information about the signal 101 is "1", "2, 0, 0" is packetized. At 1000 ns, since signal information about the signal 100 is "1", "1, 1, 2" is packetized. At 1300 ns, since signal information about the signal 101 is "1", "2, 1, 5" is packetized. At 2200 ns, since signal information about the signal 102 is "1", "3, 1, 6" is packetized. Control proceeds to step 1302. In step 1302, it is checked whether the same signal information as the information packetized in step 1008 is present in trace information about signals accumulated in the hold buffer 203. At 1300 ns, since the same trace information as that of the signal 101 generated at 800 ns is present in the hold buffer 203, control proceeds to step 1304 so as to merge the information. At 500 ns, 800 ns, 1000 ns and 2200 ns, since the same signal trace information is not present in the hold buffer 203, control proceeds to step 1303. In step 1303, the packetized trace information is stored into the hold buffer 203, and control proceeds to step 1503. In step 1304, the signal state information and CNT of the generated trace information are added to the same signal trace information present in the hold buffer 203. At 1300 ns, "1, 5" corresponding to the signal state information and CNT of the generated trace information "2, 1, 5" are added to the trace information "2, 0, 0" that is already present in the hold buffer 203, and control proceeds to step 1503. In step 1006, signal information of all signals is set to be "0", and control proceeds to step 1503.

In step 1503, the data amount of the hold buffer 203 is checked from the trace information data amount 52. At 1000 ns, since the data amount is 28, which is larger than or equal to RLIM, control proceeds to step 1504. Otherwise, control proceeds to step 1305. In step 1504, the signal 102 having a high priority level for masking is designated masking, and control proceeds to step 1305.

In step 1305, the value of the output state signal OUT is checked. When the trace information 10 is output, since OUT is "1", control proceeds to step 1306. When the trace information 10 is not output, since OUT is "0", control proceeds to step 1016. In step 1306, it is checked whether the output buffer 204 is empty. When the trace information 10 has been completely output, control proceeds to step 1309 so as to change OUT from "1" to "0". When the trace information 10 has not been completely output, control proceeds to step 1307 so as to output the trace information 10. In step 1307, information in the output buffer 204 is output as the trace information 10 through the output terminal 16, and control proceeds to step 1308. In step 1308, data that has been output is erased from the output buffer 204, and control proceeds to step 1016 so as to shift data that has not yet been output in the output buffer 204 and output the data. In step 1309, the output terminal 16 is set to be OPEN as a setting for a case when the trace information 10 is not output, and OUT is set to be "0" (a state in which the trace information 10 is not output), and control proceeds to step 1016.

In step 1016, the rising of the internal clock is checked. When the internal clock has risen, control proceeds to step 1017 so as to operate the internal counter 212. When the internal clock has not risen, control proceeds to step 1002. In step 1017, it is checked whether CNT is equal to a value that is obtained by subtracting one from CYC. At 800 ns, 1600 ns and 2400 ns, since CNT is 7 that is obtained by subtracting one from 8 that is set in CYC, control proceeds to step 1310 so as to generate the synchronization signal SYN. When CNT is not equal to the value that is obtained by subtracting one from CYC, control proceeds to step 1019. In step 1310, at 800 ns, 1600 ns and 2400 ns, the synchronization signal SYN is set to be "1", CNT is cleared to "0", the output state signal OUT is set to be "1" (i.e., an output state is set), and data accumulated in the hold buffer 203 is moved to the output buffer 204, and control proceeds to step 1002. In step 1019, it is checked whether CNT is "0". At 900 ns, 1700 ns and 2500 ns, since CNT is "0", control proceeds to step 1020 so as to clear SYN and increment CNT, and when CNT is not "0", control proceeds to step 1021 so as to simply increment CNT. In step 1020, at 900 ns, 1700 ns and 2500 ns, SYN is set to be "0", and control proceeds to step 1021 so as to increment CNT. In step 1021, CNT is incremented by 1, and control proceeds to step 1002.

### «Fifth Embodiment»

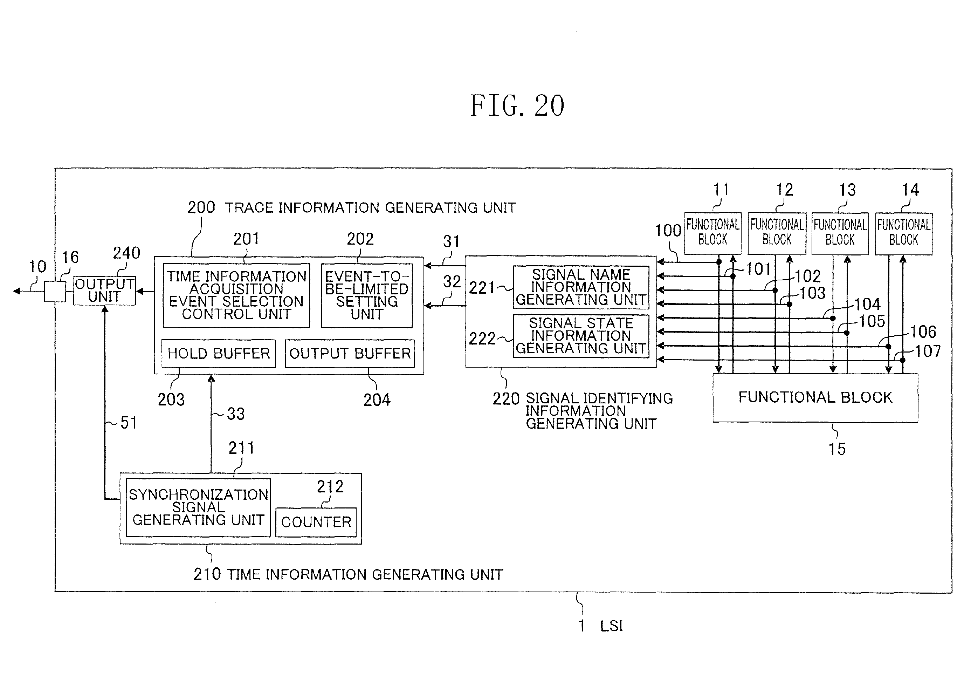

FIG. 20 is a block diagram showing a configuration of a semiconductor device according to a fifth embodiment of the present invention. In the fifth embodiment, a time information acquisition event selection control unit 201 is provided in a trace information generating unit 200, and as shown in FIG. 13(d), an event of acquiring trace information excluding time information is separated from an event of acquiring trace information including time information, thereby reducing the amount of output information, so that trace information is completely output by the time when the next synchronization signal occurs. This is applied to, for example, a case where a relationship between times of falling of internal signals 100 to 107 is investigated, only information about the occurrence of an event is acquired with respect to the rising of each signal, and it is not necessary to acquire time information.

Also, based on a data amount 52 of trace information, it is possible to automatically limit events that acquire trace information including time information. Each event is provided with a priority level for acquisition of trace information, and time information is not acquired when information is acquired in order of priority level (lowest first). The priority level can be arbitrarily changed, depending on a setting of an event-to-be-limited setting unit 202.

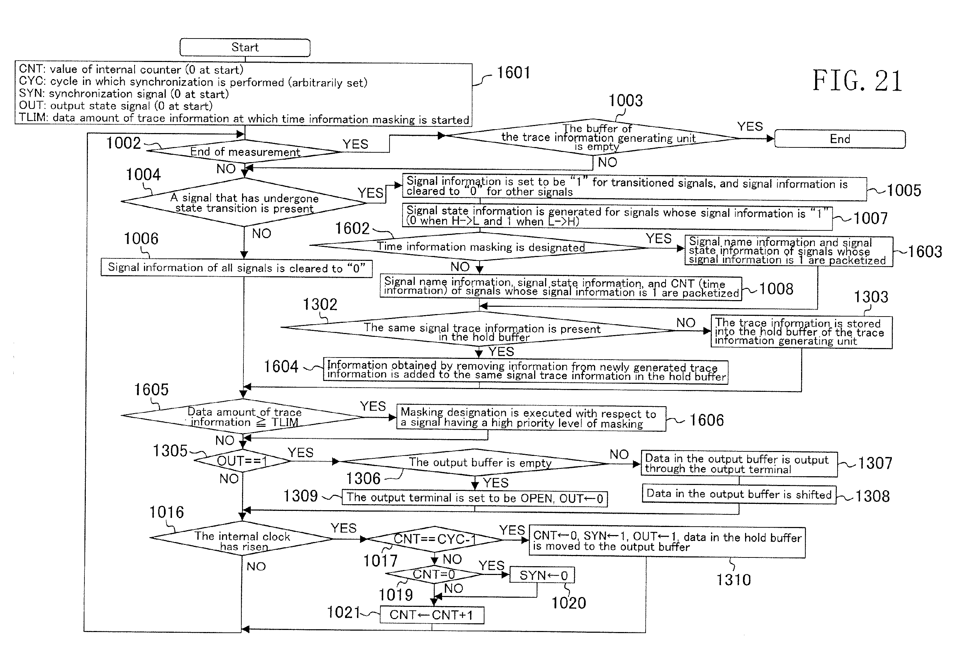

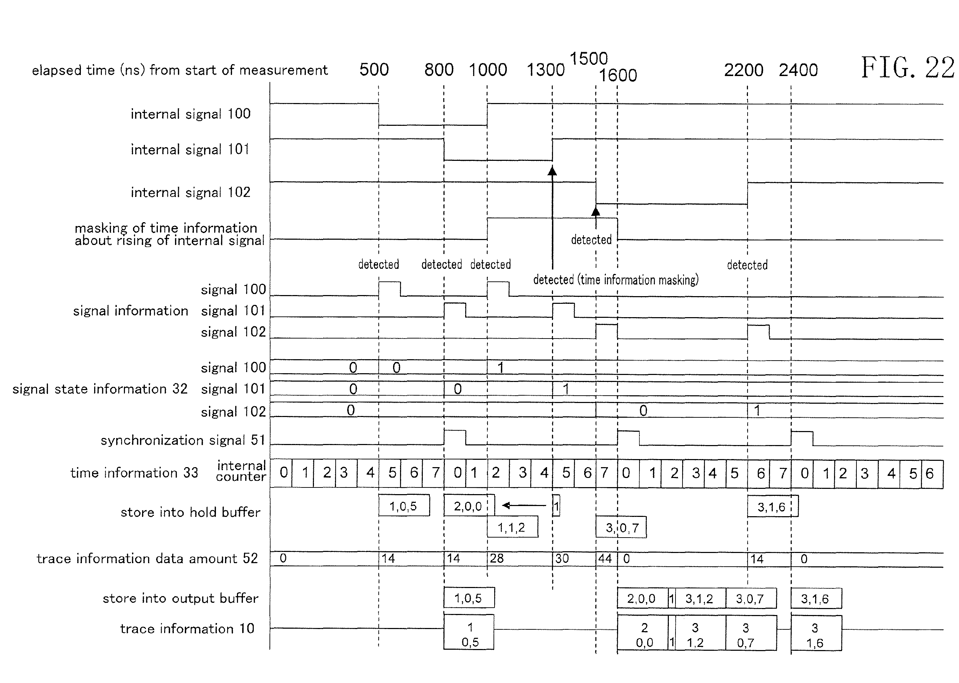

In the fifth embodiment of the present invention, a process of detection of a state transition of an internal signal, and generation of trace information 10 by an algorithm shown in FIG. 21, will be described with reference to a waveform diagram shown in FIG. 22.

In FIG. 22, the internal signal 100 is initially at H, goes to L at 500 ns from the start of measurement, and goes to H at 1000 ns. The internal signal 101 is initially at H, goes to L at 800 ns from the start of the measurement, and goes to H at 1300 ns. The internal signal 102 is initially at H, goes to L at 1500 ns from the start of the measurement, and goes to H at 2200 ns. The internal signals 103 to 107 are assumed not to undergo a state transition during the measurement. An internal clock for operating an internal counter 212 of an LSI 1 has a cycle of 100 ns, and a cycle CYC in which synchronization of the LSI 1 and a debugger 2 is performed is set to be "8". A data amount TLIM of trace information when time information masking is started is set to be "24". The unit of TLIM is bit. The priority level of time information masking is set to be high for rising and low for falling for all of the signals 100 to 102. The data amount of one set of trace information is assumed to be 14 bits, and the data amount of signal state information 32 that is added upon merger is assumed to be 2 bits.

During the start of the measurement, in step 1601, the value CNT of the internal counter 212, the synchronization signal SYN, are the output state signal OUT are set to be "0", and control proceeds to step 1002. In step 1002, it is checked whether the measurement is to be ended. When the measurement is to be ended, control proceeds to step 1003, and when the measurement is not to be ended, control proceeds to step 1004. In step 1003, it is checked whether the output buffer 204 of the trace information generating unit 200 is empty. When the output buffer 204 is empty, the flow is ended, and when the output buffer 204 is not empty, control proceeds to step 1004. In step 1004, the states of the internal signals 100 to 107 are checked. At 500 ns, 800 ns, 1000 ns, 1300 ns, 1500 ns and 2200 ns, since a signal that has undergone a state transition is present, control proceeds to step 1005 so as to generate trace information. In other cases, since no signal that has undergone a state transition is present, control proceeds to step 1006. In step 1005, for a signal that has undergone a state transition, i.e., the signal 100 at 500 ns and 1000 ns, the signal 101 at 800 ns and 1300 ns, and the signal 102 at 1500 ns and 2200 ns, signal information is set to be "1", and for the other signals, signal information is set to be "0", and control proceeds to step 1007. In step 1007, for a signal that has undergone a state transition, i.e., the signal 100 at 500 ns and 1000 ns, the signal 101 at 800 ns and 1300 ns, and the signal 102 at 1500 ns and 2200 ns, signal state information 32 is set to be "0" when the signal has gone from H to L, and "1" when the signal has gone from L to H, and control proceeds to step 1602. In step 1602, it is checked whether a signal is designated time information masking. At 1300 ns, since the rising of the signals 100 to 102 is designated time information masking, control proceeds to step 1603 so as to generate trace information excluding time information. Otherwise, control proceeds to step 1008 so as to generate trace information including time information. In step 1603, trace information excluding time information is generated. Specifically, at 1300 ns, the signal name information "2" and the signal state information "1" of the internal signal 101 are used to packetize "2, 1" as trace information, and control proceeds to step 1302. In step 1008, from signal information about a signal that has undergone a state transition, signal name information 31 indicating a signal name ("1" for the signal 100, "2" for the signal 101, "3" for the signal 102, ..., and "8" for the signal 107) is generated, and is packetized as trace information using the signal state information 32, and time information 33 including only CNT. At 500 ns, since signal information about the signal 100 is "1", "1, 0, 5" is packetized. At 800 ns, since signal information about the signal 101 is "1", "2, 0, 0" is packetized. At 1000 ns, since signal information about the signal 100 is "1", "1, 1, 2" is packetized. At 1500 ns, since signal information about the signal 102 is "1", "3, 0, 7" is packetized. At 2200 ns, since signal information about the signal 102 is "1", "3, 1, 6" is packetized. Control proceeds to step 1302. In step 1302, it is checked whether the same signal information as the information packetized in step 1008 is present in trace information about signals accumulated in the hold buffer 203. At 1300 ns, since the same trace information as that of the signal 101 generated at 800 ns is present in the hold buffer 203, control proceeds to step 1604 to merge the information. At 500 ns, 800 ns, 1000 ns, 1500 ns and 2200 ns, since the same signal trace information is not present in the hold buffer 203, control proceeds to step 1303. In step 1303, the packetized trace information is stored into the hold buffer 203, and control proceeds to step 1605. In step 1604, information that is obtained by removing signal name information from the generated trace information is added to the same signal trace information present in the hold buffer 203. At 1300 ns, "1" corresponding to the signal state information of the generated trace information "2, 1" is added to the trace information "2, 0, 0" that is already present in the hold buffer 203, and control proceeds to step 1605. In step 1006, the signal information of all signals is set to be "0", and control proceeds to step 1605.

In step 1605, the data amount of the hold buffer 203 is checked based on the data amount 52 of the trace information. At 1000 ns, since the data amount is 28, which is larger than or equal to TLIM, control proceeds to step 1606. Otherwise, control proceeds to step 1305. In step 1606, the rising of the signal 100 to 102 that is an event having a high priority level of time information masking is designated masking, and control proceeds to step 1305.

In step 1305, the value of the output state signal OUT is checked. When the trace information 10 is output, since OUT is "1", control proceeds to step 1306. When the trace information 10 is not output, since OUT is "0", control proceeds to step 1016. In step 1306, it is checked whether the output buffer 204 is empty. When the trace information 10 has been completely output, control proceeds to step 1309 so as to change OUT from "1" to "0". When the trace information 10 has not been completely output, control proceeds to step 1307 so as to output the trace information 10. In step 1307, information in the output buffer 204 is output as the trace information 10 through the output terminal 16, and control proceeds to step 1308. In step 1308, data that has been output is erased from the output buffer 204, and control proceeds to step 1016 so as to shift data that has not yet been output in the output buffer 204 and output the data. In step 1309, the output terminal 16 is set to be OPEN as a setting for a case when the trace information 10 is not output, and OUT is set to be "0" (a state in which the trace information 10 is not output), and control proceeds to step 1016.

In step 1016, the rising of the internal clock is checked. When the internal clock has risen, control proceeds to step 1017 so as to operate the internal counter 212. When the internal clock has not risen, control proceeds to step 1002. In step 1017, it is checked whether CNT is equal to a value that is obtained by subtracting one from CYC. At 800 ns, 1600 ns and 2400 ns, since CNT is 7 that is obtained by subtracting one from 8 that is set in CYC, control proceeds to step 1310 so as to generate the synchronization signal SYN. When CNT is not equal to the value that is obtained by subtracting one from CYC, control proceeds to step 1019. In step 1310, at 800 ns, 1600 ns and 2400 ns, the synchronization signal SYN is set to be "1", CNT is cleared to "0", the output state signal OUT is set to be "1" (i.e., an output state is set), and data accumulated in the hold buffer 203 is moved to the output buffer 204, and control proceeds to step 1002. In step 1019, it is checked whether CNT is "0". At 900 ns, 1700 ns and 2500 ns, since CNT is "0", control proceeds to step 1020 so as to clear SYN and increment CNT, and when CNT is not "0", control proceeds to step 1021 so as to simply increment CNT. In step 1020, at 900 ns, 1700 ns and 2500 ns, SYN is set to be "0", and control proceeds to step 1021 so as to increment CNT. In step 1021, CNT is incremented by 1, and control proceeds to step 1002.

### «Sixth Embodiment»

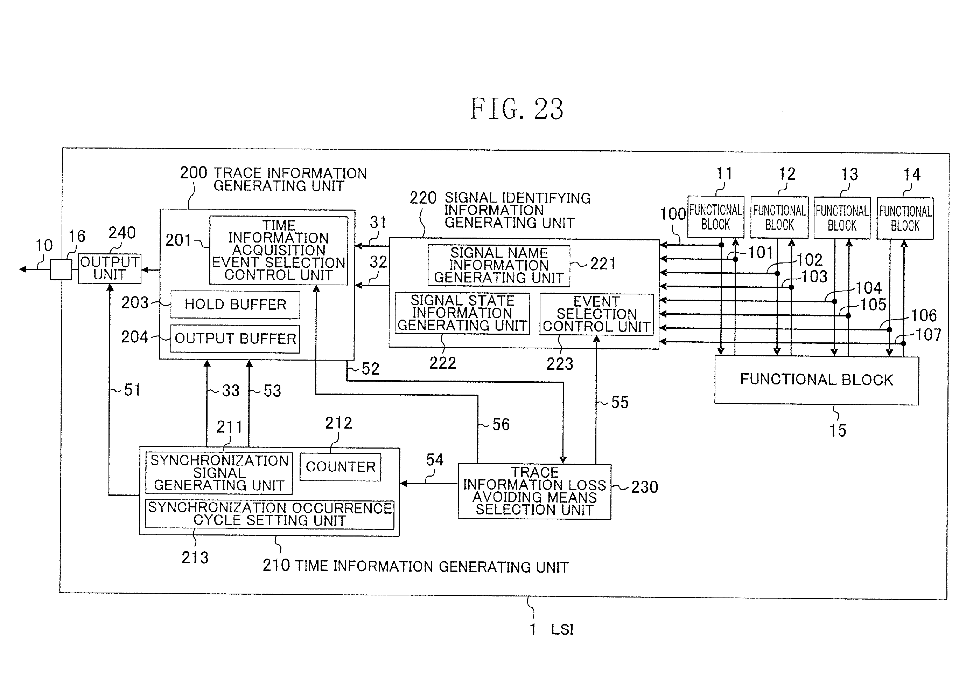

FIG. 23 is a block diagram showing a configuration of a semiconductor device according to a sixth embodiment of the present invention. In the sixth embodiment, the synchronization occurrence cycle setting unit 213 of the third embodiment, the event selection control unit 223 of the fourth embodiment, and the time information acquisition event selection control unit 201 of the fifth embodiment are all provided, and a trace information loss avoiding means selection unit 230 is used to select from the three means one means that is to be activated. This enables means for avoiding a loss of trace information to be arbitrarily selected.

Also, ON (active)/OFF (inactive) of the means for avoiding a loss of trace information can be automatically switched based on a data amount 52 of trace information in a hold buffer 203. A priority level is set in each of the trace information loss avoiding means 201, 213 and 223. When data loss is likely to occur due to the occurrence of the next synchronization signal when information is being output, one means having a high priority is activated using ON/OFF switching signals 54 to 56 of these means. The priority level can be arbitrarily changed by a setting of the trace information loss avoiding means selection unit 230.

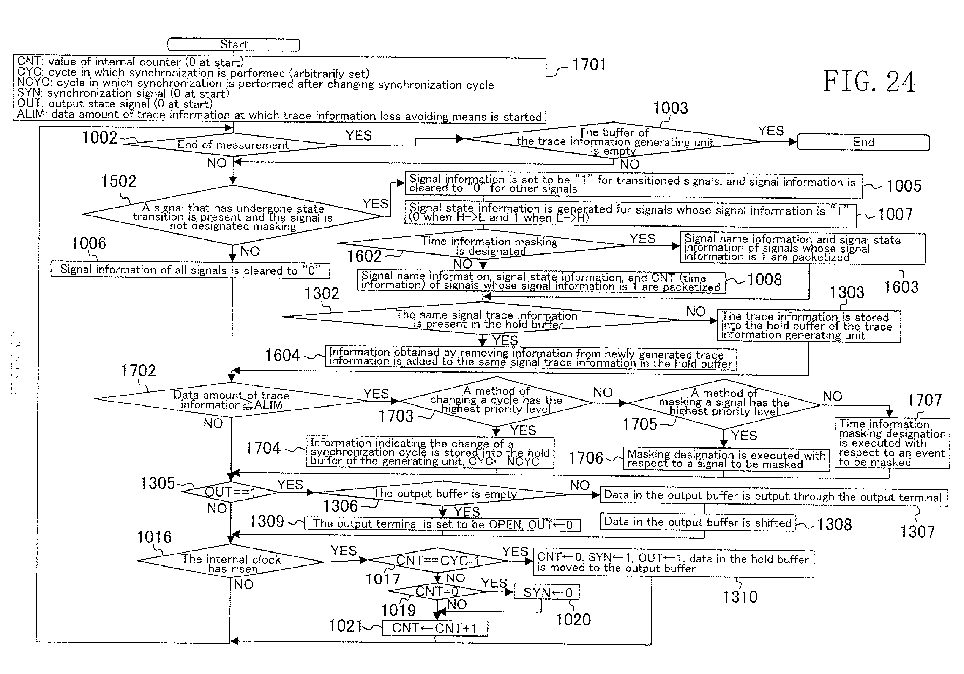

In the sixth embodiment of the present invention, a process of detection of a state transition of an internal signal, and generation of trace information 10 by an algorithm shown in FIG. 24 will be described. When a method of masking time information is given the highest priority level, the same waveform as that of FIG. 22 is obtained. Therefore, a description will be given with reference to FIG. 22.

In FIG. 22, the internal signal 100 is initially at H, goes to L at 500 ns from the start of measurement, and goes to H at 1000 ns. The internal signal 101 is initially at H, goes to L at 800 ns from the start of the measurement, and goes to H at 1300 ns. The internal signal 102 is initially at H, goes to L at 1500 ns from the start of the measurement, and goes to H at 2200 ns. The internal signals 103 to 107 are assumed not to undergo a state transition during the measurement. An internal clock for operating an internal counter 212 of an LSI 1 has a cycle of 100 ns. A cycle CYC in which synchronization of the LSI 1 and a debugger 2 is performed is set to be "8". A data amount ALIM of trace information for activating the trace information loss avoiding means 201, 213 and 223 is set to be "24". The unit of ALIM is bit. The trace information loss avoiding means selection unit 230 gives a high priority level to the method of masking time information and a low priority level to the other methods. When time information masking is executed, time information about the falling of signals 100 to 102 is set to be masked. The data amount of one set of trace information is assumed to be 14 bits, and a data amount of signal state information added upon merger is assumed to be 2 bits.

During the start of the measurement, in step 1701, the value CNT of the internal counter 212, the synchronization signal SYN, are the output state signal OUT are set to be "0", and control proceeds to step 1002. In step 1002, it is checked whether the measurement is to be ended. When the measurement is to be ended, control proceeds to step 1003, and when the measurement is not to be ended, control proceeds to step 1502. In step 1003, it is checked whether the output buffer 204 of the trace information generating unit 200 is empty. When the output buffer 204 is empty, the flow is ended, and when the output buffer 204 is not empty, control proceeds to step 1502. In step 1502, the states of the internal signals 100 to 107 are checked. At 500 ns, 800 ns, 1000 ns, 1300 ns, 1500 ns and 2200 ns, since a signal that has undergone a state transition is present, and no signals at the times are designated masking, control proceeds to step 1005 so as to generate trace information. In other cases, since no signal that has undergone a state transition is present, control proceeds to step 1006. In step 1005, for a signal that has undergone a state transition, i.e., the signal 100 at 500 ns and 1000 ns, the signal 101 at 800 ns and 1300 ns, and the signal 102 at 1500 ns and 2200 ns, signal information is set to be "1", and for the other signals, signal information is set to be "0", and control proceeds to step 1007. In step 1007, for a signal that has undergone a state transition, i.e., the signal 100 at 500 ns and 1000 ns, the signal 101 at 800 ns and 1300 ns, and the signal 102 at 1500 ns and 2200 ns, signal state information 32 is set to be "0" when the signal has gone from H to L, and "1" when the signal has gone from L to H, and control proceeds to step 1602. In step 1602, it is checked whether the signal is designated time information masking. At 1300 ns, since the rising of the signals 100 to 102 is designated time information masking, control proceeds to step 1603 so as to generate trace information excluding time information. Otherwise, control proceeds to step 1008 so as to generate trace information including time information. In step 1603, trace information excluding time information is generated. At 1300 ns, the signal name information "2" and the signal state information "1" of the internal signal 101 are used to packetize "2, 1" as trace information, and control proceeds to step 1302. In step 1008, from signal information about a signal that has undergone a state transition, signal name information 31 indicating a signal name ("1" for the signal 100, "2" for the signal 101, "3" for the signal 102, ..., and "8" for the signal 107) is generated, and is packetized as trace information using the signal state information 32, and time information 33 including only CNT. At 500 ns, since signal information about the signal 100 is "1", "1, 0, 5" is packetized. At 800 ns, since signal information about the signal 101 is "1", "2, 0, 0" is packetized. At 1000 ns, since signal information about the signal 100 is "1", "1, 1, 2" is packetized. At 1500 ns, since signal information about the signal 102 is "1", "3, 0, 7" is packetized. At 2200 ns, since signal information about the signal 102 is "1", "3, 1, 6" is packetized. Control proceeds to step 1302. In step 1302, it is checked whether the same signal information as the information packetized in step 1008 is present in trace information about signals accumulated in the hold buffer 203. At 1300 ns, since the same trace information as that of the signal 101 generated at 800 ns is present in the hold buffer 203, control proceeds to step 1604 so as to merge the information. At 500 ns, 800 ns, 1000 ns, 1500 ns and 2200 ns, since the same signal trace information is not present in the hold buffer 203, control proceeds to step 1303. In step 1303, since the packetized trace information is stored into the hold buffer 203, control proceeds to step 1702. In step 1604, information that is obtained by removing signal name information from the generated trace information is added to the same signal trace information present in the hold buffer 203. At 1300 ns, "1" corresponding to the signal state information of the generated trace information "2, 1" is added to the trace information "2, 0, 0" that is already present in the hold buffer 203, and control proceeds to step 1702. In step 1006, the signal information of all signals is set to be "0", and control proceeds to step 1702.

In step 1702, the data amount of the hold buffer 203 is checked from the trace information data amount 52. At 1000 ns, since the data amount is 28, which is larger than or equal to ALIM, control proceeds to step 1703. Otherwise, control proceeds to step 1305. In step 1703, a priority level set in the trace information loss avoiding means selection unit 230 is checked. When the method of changing the synchronization cycle has the highest priority level, control proceeds to step 1704 so as to change the synchronization cycle. When a method other than the method of changing the synchronization cycle has the highest priority level, control proceeds to step 1705. In step 1704, the synchronization occurrence cycle setting unit 213 is operated in accordance with a synchronization occurrence cycle setting unit ON/OFF switching signal 54, and information about the change of the synchronization cycle is output to the trace information generating unit 200. In response to this, the information "0, 0, 0" about the change of the synchronization cycle is stored into the hold buffer 203, and the time information generating unit 210 updates the synchronization cycle CYC with the value of NCYC, and control proceeds to step 1305. In step 1705, a priority level set in the trace information loss avoiding means selection unit 230 is checked. When a method of masking signal information acquisition has the highest priority level, control proceeds to step 1706 so as to designate signal masking. When a method other than the method of masking signal information acquisition has the highest priority level, this means that the method of masking time information has the highest priority level, control proceeds to step 1707 so as to designate time information masking. In step 1706, the event selection control unit 223 is operated in accordance with an event selection control unit ON/OFF switching signal 55, and a signal that has been set so that it is to be masked is designated masking, and control proceeds to step 1305. In step 1707, the time information acquisition event selection control unit 201 is operated in accordance with a time information acquisition event selection control unit ON/OFF switching signal 56, and a signal that has been set so that it is to be masked during execution of time information masking is designated time information masking. Time information about the falling of the signals 100 to 102 that has been set so that it is to be masked during execution of time information masking is designated masking, and control proceeds to step 1305.

In step 1305, the value of the output state signal OUT is checked. When the trace information 10 is output, since OUT is "1", control proceeds to step 1306. When the trace information 10 is not output, since OUT is "0", control proceeds to step 1016. In step 1306, it is checked whether the output buffer 204 is empty. When the trace information 10 has been completely output, control proceeds to step 1309 so as to change OUT from "1" to "0". When the trace information 10 has not been completely output, control proceeds to step 1307 so as to output the trace information 10. In step 1307, information in the output buffer 204 is output as the trace information 10 through the output terminal 16, and control proceeds to step 1308. In step 1308, data that has been output is erased from the output buffer 204, and control proceeds to step 1016 so as to shift data that has not yet been output in the output buffer 204 and output the data. In step 1309, the output terminal 16 is set to be OPEN as a setting for a case when the trace information 10 is not output, and OUT is set to be "0" (a state in which the trace information 10 is not output), and control proceeds to step 1016.

In step 1016, the rising of the internal clock is checked. When the internal clock has risen, control proceeds to step 1017 so as to operate the internal counter 212. When the internal clock has not risen, control proceeds to step 1002. In step 1017, it is checked whether CNT is equal to a value that is obtained by subtracting one from CYC. At 800 ns, 1600 ns and 2400 ns, since CNT is 7 that is obtained by subtracting one from 8 that is set in CYC, control proceeds to step 1310 so as to generate the synchronization signal SYN. When CNT is not equal to the value that is obtained by subtracting one from CYC, control proceeds to step 1019. In step 1310, at 800 ns, 1600 ns and 2400 ns, the synchronization signal SYN is set to be "1", CNT is cleared to "0", the output state signal OUT is set to be "1" (i.e., an output state is set), and data accumulated in the hold buffer 203 is moved to the output buffer 204, and control proceeds to step 1002. In step 1019, it is checked whether CNT is "0". At 900 ns, 1700 ns and 2500 ns, since CNT is "0", control proceeds to step 1020 so as to clear SYN and increment CNT, and when CNT is not "0", control proceeds to step 1021 so as to simply increment CNT. In step 1020, at 900 ns, 1700 ns and 2500 ns, SYN is set to be "0", and control proceeds to step 1021 so as to increment CNT. In step 1021, CNT is incremented by 1, and control proceeds to step 1002.

### INDUSTRIAL APPLICABILITY

As described above, the semiconductor device and the development supporting device of the present invention are useful as means for externally analyzing and evaluating the behavior of an LSI internal signal.

## Claims

1. A semiconductor device comprising:
means for acquiring information about a signal name and information about a signal state from information about transition of an internal signal;
means for encoding the signal name information and the signal state information; and
means for outputting a result of the encoding as trace information.

2. The semiconductor device of claim 1, further comprising:
means for generating time information representing time inside the semiconductor device;
means for encoding the time information; and
means for adding a result of the encoding of the time information as a part of the trace information.

3. The semiconductor device of claim 1, further comprising:
means for generating first time information representing timing of a synchronization signal;
means for generating second time information representing time inside the semiconductor device with respect to the first time information;
means for encoding the first and second time information; and
means for adding a result of the encoding of the first and second time information as a part of the trace information.

4. A development supporting device receiving the trace information from the semiconductor device of claim 3, comprising:
means for decoding the trace information to acquire the signal name information, the signal state information, and the first and second time information;
means for calculating real-time information from the first and second time information; and
means for reproducing information about a waveform of the internal signal of the semiconductor device using the signal name information, the signal state information and the real-time information.

5. The semiconductor device of claim 2, further comprising:
means for accumulating the trace information to be output; and
means for outputting the accumulated trace information in synchronization with timing of a synchronization signal.

6. The semiconductor device of claim 5, further comprising:
means for changing the timing of the synchronization signal.

7. The semiconductor device of claim 5, further comprising:
means for limiting an event of acquiring the signal name information and the signal state information.

8. The semiconductor device of claim 5, further comprising:
means for putting a limitation so as to output partial trace information excluding the time information.

9. The semiconductor device of claim 5, further comprising:
first means for changing the timing of the synchronization signal;
second means for limiting an event of acquiring the signal name information and the signal state information;
third means for putting a limitation so as to output partial trace information excluding the time information; and
fourth means for selecting and activating one of the first, second and third means.

10. The semiconductor device of claim 5, further comprising:
means for automatically changing the timing of the synchronization signal based on a data amount of the accumulated trace information.

11. The semiconductor device of claim 5, further comprising:
means for automatically limiting an event of acquiring the signal name information and the signal state information based on a data amount of the accumulated trace information.

12. The semiconductor device of claim 5, further comprising:
means for automatically putting a limitation so as to output partial trace information excluding the time information based on a data amount of the accumulated trace information.

13. The semiconductor device of claim 9, wherein
the fourth means causes the first means to operate to automatically change the timing of the synchronization signal based on a data amount of the accumulated trace information, the second means to operate to automatically limit an event of acquiring the signal name information and the signal state information, or the third means to operate to automatically put a limitation so as to output partial trace information excluding the time information.

14. The semiconductor device of claim 11, further comprising:
means for determining an event of not acquiring the signal name information and the signal state information in accordance with a preset order of priority.

15. The semiconductor device of claim 12, further comprising:
means for determining an event of outputting the trace information excluding the time information in accordance with a preset order of priority.
